# FASCICULE DE BREVET EUROPEEN

(11) **EP 3 047 703 B1**
(45) Date de publication et mention de la délivrance du brevet: **26.06.2019**
(21) Numéro de dépôt: 14784301.5
(22) Date de dépôt: 16.09.2014
(51) Int. Cl.: F21Y 101/00, F21S 2/00, F21S 8/08, H05B 33/08, H05B 37/02, H05K 1/18, F21Y 115/10

(54) **MODULE PROGRAMMABLE POUR UNE INSTALLATION MODULAIRE D'ÉMETTEURS DE SIGNAUX ET PROCÉDÉ DE PILOTAGE DE L'INSTALLATION**
PROGRAMMIERBARES MODUL FÜR EINE MODULARE INSTALLATION VON SIGNALGEBERN UND VERFAHREN ZUR ANSTEUERUNG DER INSTALLATION
PROGRAMMABLE MODULE FOR A MODULAR INSTALLATION OF SIGNAL TRANSMITTERS AND METHOD OF DRIVING THE INSTALLATION

(30) Priorité: 20.09.2013 FR 1359064
(43) Date de publication de la demande: 27.07.2016
(73) Titulaire: Université d'Aix-Marseille, 13284 Marseille Cedex 07 (FR); Centre National de la Recherche Scientifique, 75016 Paris (FR)
(72) Inventeur: NIEBERT, Peter, 13008 Marseille (FR); CARALP, Mathieu, 05000 Gap (FR)
(74) Mandataire: Chevalier, Renaud Philippe
(86) Numéro de dépôt international: PCT/FR2014/052303
(87) Numéro de publication internationale: WO 2015/040324

(56) Documents cités:
- WO-A1-91/08565
- WO-A1-2011/106623
- WO-A1-2011/123920
- WO-A2-2010/116283
- WO-A2-2012/087901
- US-A1- 2007 182 676

## Description

La présente invention se rapporte à un module programmable pour une installation modulaire d'émetteurs de signaux, notamment du type émetteur de signaux lumineux.

Elle se rapporte également à une installation modulaire du type comprenant plusieurs tels modules, ainsi qu'à un procédé de pilotage d'une telle installation modulaire.

La présente invention trouve une application particulière dans le domaine des modules lumineux, autrement dit des modules intégrant des émetteurs de signaux lumineux, autrement appelés sources lumineuses.

Cependant, la présente invention est susceptible d'application dans d'autres domaines, avec des modules intégrant des émetteurs de signaux d'autres types que lumineux, comme par exemple des signaux sonores.

Il est connu d'intégrer plusieurs modules lumineux en réseau au sein d'une installation. A titre d'exemple, les documents WO 2011/106623, WO 2010/116283 et WO 2011/123920 divulguent chacun un réseau de modules lumineux pilotés par un ou plusieurs contrôleurs et organisés de manière hiérarchique, notamment selon une organisation en douche.

Une problématique tient à la mise en oeuvre classique d'une hiérarchisation des modules, autrement dit une organisation des modules selon une hiérarchie prédéfinie qui nécessite l'emploi d'une couche de réseau entre un contrôleur et chaque module lumineux. Une telle hiérarchisation impose donc des limites en termes de taille, car la couche de réseau du contrôleur est nécessairement limitée à un nombre maximal de modules lumineux avec lequel il peut communiquer. Ainsi, les dimensions de l'installation ou le nombre de modules présents dans l'installation vont être limités par les limites de la couche de réseau, interdisant toute extension de l'installation au-delà d'un seuil critique.

L'état de la technique peut également être illustré par l'enseignement du document WO 91/08565 qui concerne un dispositif d'affichage vidéo modulaire comportant plusieurs modules d'affichage disposés dans un réseau bidimensionnel et recevant des signaux vidéo en provenance d'une unité d'interface reliée à l'un des modules d'affichage. Chaque module d'affichage est comprend une face avant d'affichage à cristaux liquides présentant une pluralité de pixels, une face arrière sur laquelle est prévu un circuit de commande et des connecteurs prévus sur les arêtes du module d'affichage permettant de coupler un module d'affichage avec quatre modules d'affichage adjacents ou avec l'unité d'interface. Le circuit de commande de chaque module d'affichage reçoit des signaux vidéo et une alimentation électrique sur un connecteur d'une arête et il convoie ces signaux vidéo et cette alimentation électrique sur les connecteurs des autres arêtes. Par ailleurs, le circuit de commande de chaque module d'affichage effectue un décodage des signaux vidéo afin d'adapter l'affichage sur les pixels de la face avant en fonction de la dimension du réseau bidimensionnel et de la position verticale et horizontale du module au sein de ce réseau bidimensionnel. Ce dispositif d'affichage présente l'inconvénient de ne pas autoriser une communication bidirectionnelle entre les modules d'affichage et donc de restreindre son fonctionnement à un décodage limité car pré-chargé dans les circuits de commande.

La présente invention se propose de résoudre cet inconvénient en proposant un module programmable qui permet d'augmenter la taille de l'installation modulaire par ajout de modules, autrement dit par la connexion de nouveaux modules sur les modules existants, avec l'avantage d'avoir une installation « scalable », c'est-à-dire adaptée à un changement d'échelle tout en maintenant sa fonctionnalité première (émission de signaux, par exemple lumineux) par ajout graduel de modules.

La présente invention concerne également un procédé de pilotage associé qui met en oeuvre une propagation d'algorithmes distribués de proche en proche, selon un fonctionnement cyclique, périodique et synchrone.

A cet effet, elle propose un module programmable selon la revendication 1.

Ainsi, plusieurs modules conformes à l'invention peuvent être connectés physiquement entre eux et communiquer entre modules voisins grâce à leurs connecteurs, avec l'avantage que ces connecteurs ou interfaces de communication bidirectionnelle permettent de piloter de manière quasi synchrone les modules, pour au final obtenir un module « intelligent » qui émet des signaux suivant son environnement réseau (à savoir ces modules voisins ou du moins proches).

Dans le cadre de l'invention, au moins un émetteur de signaux est un émetteur de signaux lumineux, notamment du type diode électroluminescente.

De cette manière, l'invention trouve une application particulièrement avantageuse dans les installations de modules lumineux, telles que l'éclairage intérieur ou extérieur, l'affichage, etc.

Selon une autre caractéristique, le module comprend en outre au moins un capteur de mesure d'un paramètre local fixé sur l'embase, ledit au moins un capteur générant des données de mesure locale et le contrôleur étant relié audit au moins un capteur pour recevoir lesdites données de mesure locale.

Ainsi, il est possible de prendre en compte l'environnement externe local de chaque module grâce au(x) capteur(s), pour obtenir un module« intelligent » qui émet des signaux suivant également son environnement externe local (grâce aux mesures du ou des capteurs).

Le capteur de mesure peut être du type capteur de proximité, mais d'autres types de capteur peuvent bien entendu être envisagés, tels que capteur de pression, capteur de température, capteur de luminosité, etc.

Le capteur de proximité détecte l'approche d'un objet ou d'une personne, et le contrôleur intègre cette donnée de mesure pour éventuellement (en fonction de l'algorithme de pilotage) modifier le pilotage du ou des émetteurs de signaux. Autrement dit, le contrôleur réagit à cette approche en faisant varier les émissions des signaux.

Dans une réalisation particulière, le module comporte un connecteur sur chaque arête, afin que chaque arête du module puisse être connectée avec l'arête d'un module similaire voisin, pour éventuellement pouvoir obtenir un pavage complet d'une surface au moyen des modules interconnectés.

L'invention se rapporte également à une installation modulaire du type comprenant plusieurs modules conformes à l'invention, dans laquelle chaque module présente au moins un connecteur connecté à un connecteur d'un module voisin.

Cette installation est totalement « scalable », ainsi que définie précédemment, permettant ainsi d'avoir des installations de taille arbitraire, suivant le nombre de modules employés ; étant précisé que plus il y a de modules dans l'installation, et plus il y a de contrôleurs pour exécuter l'algorithme de pilotage de l'installation en parallèle. Une telle installation présente l'avantage qu'elle ne nécessite pas de bus centralisé de communication, puisque la communication est locale entre modules voisins dans l'installation grâce à leurs interfaces de communication bidirectionnelle et, ainsi, plus l'installation est grande et plus celle-ci présente des canaux locaux de communication.

Dans l'installation, le montage et la structure des modules garantit une communication locale entre les modules qui facilite le câblage : il suffit en effet d'alimenter l'installation de modules en réseau à un nombre suffisant de connecteurs de module pour distribuer le courant à l'ensemble des modules via leurs interfaces d'alimentation électrique. Pour la communication de données, et en particulier du ou des algorithmes distribués, un seul connecteur suffit pour introduire l'algorithme à l'intérieur du réseau entier.

Cette installation est particulièrement avantageuse car les interfaces de communication entre modules voisins assurent une communication locale rapide en fonction de la bande passante des interfaces du contrôleur. La communication globale à travers des protocoles sera soumise à des contraintes de latence qui dépendent de la taille de l'installation, mais l'invention envisage un protocole de communication qui réalise un « broadcast » d'une bande passante très faible, mais d'une latence négligeable à partir d'un point d'origine.

Ainsi, les contrôleurs réalisent les tâches de communication eux-mêmes et gèrent en plus le pilotage des émetteurs de signaux et la lecture des données de mesure issues des capteurs, sans l'utilisation de composants actifs supplémentaires.

Avantageusement, l'installation comprend en outre une source unique d'un programme de pilotage des contrôleurs des modules, ladite source externe étant prévue pour être connectée à un contrôleur d'un module dit maître.

Cette source peut constituée d'une source externe de chargement du programme qui est connectée à un connecteur du module maître, ou bien une unité de stockage ou mémoire dans laquelle est mémorisé le programme et qui est branchée sur le module maître.

L'invention se rapporte aussi à un procédé de pilotage selon la revendication 9.

La particularité de ce procédé de pilotage réside ainsi dans un fonctionnement quasi-synchrone entre modules voisins de l'installation, avec une programmation synchrone. Autrement dit, chaque module exécute le même programme dans un mode de programmation pseudoparallèle, pour qu'au final chaque contrôleur pilote le ou les émetteurs de signaux de son module par la mise en oeuvre d'un même programme.

Il est entendu que si les modules sont de différents types (notamment en termes de géométrie de l'embase et/ou de nombre de connecteurs), le même programme exécuté par tous les modules peut être paramétré de sorte que l'exécution de ce programme par un module de type I donne lieu à l'exécution de certains algorithmes du programme, et l'exécution de ce programme par un module de type II donne lieu à l'exécution de certains autres algorithmes du programme. Il peut ainsi y avoir quelques différenciations dans l'exécution du même programme, suivant le type du module.

Le procédé fonctionne donc sur la base d'un langage synchrone qui accède aux contrôleurs pour que chaque contrôleur réalise des tâches simples : pilotage et surveillance du ou des émetteurs de signaux, communication avec les contrôleurs du ou des modules voisins, lecture du ou des capteurs, écoute sur les interfaces de communication, réception et transmission de données sur ces interfaces de communication.

La programmation est aussi parallèle sur un même module ce qui permet de réaliser plusieurs fonctions temps réel indépendantes. Il est également envisageable que la communication entre modules voisins soit une communication parallèle réalisée sur plusieurs canaux virtuels, de sorte que plusieurs algorithmes de pilotage distribués peuvent s'exécuter en parallèle.

De manière avantageuse, un module dit maître constitue une source unique du rythme périodique pour l'exécution du même programme par les modules, où ledit module maître génère un signal de synchronisation qui est propagé de proche en proche entre les modules en partant du module maître via leurs connecteurs respectifs.

Ce signal de synchronisation permet avantageusement de caler la synchronisation entre les modules, en le propageant à travers tous les modules ; chaque module réceptionnant le signal de synchronisation pour aussitôt le transmettre aux modules voisins.

Selon une possibilité de l'invention, l'exécution du même programme par les modules est précédée d'une phase d'entrée d'un algorithme de pilotage au contrôleur d'au moins un module dit maître, sous la forme de trames de données répartis dans des cycles périodiques successifs, les autres modules étant dits esclaves, et dans lequel l'exécution du même programme par les modules comporte les phases suivantes :
- une première phase d'exécution d'un algorithme de distribution dans lequel des trames de données de l'algorithme de pilotage sont distribuées de manière synchrone et périodique, de proche en proche entre les modules (1) en partant d'un au moins un module dit maître ;
- une fois que l'algorithme de pilotage distribué est complètement chargé dans tous les contrôleurs, une seconde phase d'exécution de l'algorithme de pilotage par chaque contrôleur de manière synchrone et périodique.

Ainsi, chaque module exécute dans la seconde phase le même algorithme de pilotage dans un mode de programmation pseudoparallèle, les contrôleurs exécutant de manière synchrone cet algorithme préalablement distribué durant la première phase, ce qui implique par exempel la mise en oeuvre d'un bootloader distribué pour la première phase, autrement dit la distribution de l'algorithme de pilotage à partir d'une seule source.

Dans un mode de réalisation particulier, la première phase de distribution est précédée d'une phase de détermination d'une distance maximale correspondant à la plus grande distance entre le au moins un module maître et le ou les modules esclaves les plus éloignés dans l'installation en cheminant de module voisin en module voisin selon le ou les chemins les plus courts, pour établir le temps nécessaire à la phase de distribution pour que l'algorithme de pilotage distribué soit complètement chargé dans tous les contrôleurs.

De cette manière, le procédé est certain que tous les modules ont bien chargé l'algorithme de pilotage avant d'amorcer la phase d'exécution. Autrement dit, tous les modules attendent que la dernière donnée de l'algorithme de pilotage ait été distribuée dans le « dernier » module (la distribution se faisant au même rythme et de proche en proche), ce qui garantit que le démarrage de l'algorithme de pilotage se fait de manière synchrone.

Selon une caractéristique, la phase de détermination de la distance maximale est réalisée soit en établissant la topologie de l'installation, soit en faisant circuler, de proche en proche entre les modules, une fonction d'estimation de la distance maximale qui évolue au fur et à mesure de sa propagation dans l'installation jusqu'à atteindre un maximum correspondant à la distance maximale.

Selon une possibilité de l'invention, la phase d'entrée de l'algorithme de pilotage et la première phase d'exécution de l'algorithme de distribution sont réalisées :
- soit de manière séquentielle, où ladite première phase débute une fois que l'algorithme de pilotage est complètement chargé dans le contrôleur du au moins un module maître ;
- soit de manière parallèle, où chaque contrôleur d'un module reçoit dans un cycle courant une trame de données de l'algorithme de pilotage et la propage au(x) contrôleur(s) du ou des modules voisins dans le cycle suivant.

Selon une autre possibilité de l'invention, lors de la première phase d'exécution de l'algorithme de distribution, à chaque cycle, le contrôleur de chaque module réalise les opérations suivantes :
- réception d'un signal de synchronisation sur au moins une entrée de communication, et transmission du signal de synchronisation sur les sorties de communication ;
- écoute sur toutes les entrées de communication du module ;
- réception d'une trame de données de l'algorithme de pilotage sur au moins une entrée de communication du module, ladite trame de données correspondant à une trame de données transmise lors du cycle précédent par un module voisin sur la sortie de communication connectée à ladite entrée de communication du module ;
- stockage de ladite trame de données dans ledit contrôleur ;
- transmission de ladite trame de données sur les sorties de communication à destination des modules voisins.

Conformément à une caractéristique de l'invention, lors de la seconde phase d'exécution de l'algorithme de pilotage, à chaque cycle, le contrôleur de chaque module réalise les opérations suivantes :
- réception d'un signal de synchronisation sur au moins une entrée de communication, et transmission du signal de synchronisation sur les sorties de communication ;
- écoute sur toutes les entrées de communication du module ;
- lecture des données de mesure issues du au moins capteur ;
- lecture de variables dites d'état représentatives de l'état du module, notamment de l'état du au moins un émetteur de signaux ;
- lecture d'un paquet de données dit entrant sur au moins une entrée de communication du module, ledit paquet de données intégrant au moins une variable d'entrée pour l'exécution de l'algorithme de pilotage ;
- exécution de l'algorithme de pilotage avec en entrée la ou les variables d'entrée du ou des paquets de données reçus dans le cycle courant, les données de mesure et les variables d'état, et en sortie des instructions de pilotage du ou des émetteurs de signaux du module, une mise à jour des variables d'état, et le calcul de variables de sortie associées à chaque sortie de communication ;
- transmission sur chaque sortie de communication d'un paquet de donnée dit sortant intégrant les variables de sortie associées à chaque sortie de communication.

En pratique, l'état de chaque module est représenté par des variables qui lui sont propres, autrement appelées des variables locales, et il en existe trois types dans la présente installation :
- les variables d'entrée qui sont lues sur les entrées de communication, qui ne dépendent pas du module et dont les valeurs viennent de l'extérieur ;
- les variables de sortie, que le contrôleur génère après exécution de l'algorithme de pilotage et qu'il modifie pour communiquer avec les modules voisins ; et
- les autres variables qui représentent son état, à savoir les variables d'état qui traduisent par exemple l'état du ou des émetteurs de signaux, et les données de mesure issues du ou des capteurs.

A ce titre, chaque contrôleur de module est conformé pour mémoriser ces variables, et pour réaliser des comportements ou fonctions complexes. Par exemple, un contrôleur peut utiliser un ou plusieurs compteurs pour compter le temps avant de changer une sortie (introduisant ainsi un délai d'attente), peut utiliser plusieurs données de mesure consécutives issues d'un capteur pour réaliser des filtres, etc.

Il est également envisageable que, lors de la seconde phase d'exécution de l'algorithme de pilotage, à chaque cycle, le ou chaque paquet de donnée entrant dans un cycle courant correspond à un paquet de donnée sortant transmis lors du cycle précédent par un module voisin sur la sortie de communication connectée à ladite entrée de communication du module, et le ou chaque paquet de donnée sortant transmis dans un cycle courant est réceptionné par le module voisin concerné dans le cycle suivant.

Ce cas de figure correspond à une communication directe de proche en proche entre un module de rang n et un module de rang n+1.

Il est également envisageable qu'un module de rang n puisse également communiquer avec un module voisin de rang n+2 évitant ainsi d'introduire deux cycles de retard entre ces deux modules. Il est bien entendu possible d'étendre cette communication entre voisins éloignés à des écarts de rang supérieurs à 2. Une telle approche de communication entre voisins éloignés permet à un module de regarder plus loin que ses voisins directs, ce qui peut s'avérer très avantageux pour optimiser des comportements locaux.

Selon une première possibilité, la seconde phase d'exécution de l'algorithme de pilotage comprend, de préférence au début de la seconde phase, une phase de communication avec une source unique de rythme sans contrôle de gigue, la source unique de rythme étant donnée par le signal de synchronisation au début de chaque cycle envoyé par le contrôleur du au moins un module maître.

De manière avantageuse, cette phase de communication avec une source unique de rythme sans contrôle de gigue est réalisée comme suit : durant chaque période, le contrôleur de chaque module esclave non maître situé à un rang n par rapport au module maître, distribue un paquet de données se subdivisant en plusieurs intervalles de temps alloués de la manière suivante :
- un premier intervalle de temps alloué au signal de synchronisation ;
- un second intervalle de temps dit d'attente vide de données, ledit second intervalle de temps présentant une durée T2 où :
   T2 ≥ ε + γ, avec
   ε le temps de propagation minimal entre le contrôleur d'un module et le contrôleur du module voisin suivant ; et
   γ la gigue du cycle ;
- un troisième intervalle de temps alloué aux variables de sortie ; et
- un quatrième intervalle de temps dit de pause, ledit quatrième intervalle de temps présentant une durée T4, où
   T4 ≥ ε + nγ, avec
   n le rang du module par rapport au module maître dans la chaîne de communication.

On parle alors d'un fonctionnement localement synchrone sans contrôle de gigue, avec une seule source de rythme. Ce fonctionnement est à privilégier pour le démarrage de l'installation, ainsi que pour la détection de modules défaillants.

Selon une seconde possibilité, la seconde phase d'exécution de l'algorithme de pilotage comprend, de préférence après le démarrage de l'installation, une phase de communication avec un nombre variable de source de rythme et avec contrôle de gigue, dans lequel un contrôleur d'au moins un module esclave génère son propre signal de synchronisation qu'il transmet aux modules voisins sur ses sorties de communication.

De manière avantageuse, cette phase de communication avec un nombre variable de source de rythme et avec contrôle de gigue est réalisée comme suit : le contrôleur de chaque module esclave réalise les étapes suivantes :
- s'il s'est écoulé, depuis la réception du signal de synchronisation du paquet de données du cycle précédent provenant d'un module voisin dit précédent, un intervalle de temps dit de retard Tretard, alors ledit contrôleur transmet un paquet de données avec un signal de synchronisation aux autres modules voisins dits suivants sans attendre le signal de synchronisation du paquet de données du cycle suivant qui proviendra dudit module voisin précédent, où :
   Tretard = P + ε + γ, avec
   P la durée du cycle du module maître ;
   ε le temps de propagation minimal entre le contrôleur d'un module et le contrôleur du module voisin suivant ; et
   γ la gigue du cycle ;
- si, à la réception du signal de synchronisation d'un paquet de données du cycle courant provenant d'un module voisin précédent, il existe, depuis la réception du signal de synchronisation du cycle précédent provenant dudit module voisin précédent, un intervalle de temps dit d'avance Tavance, alors le contrôleur attend un intervalle de temps Tdécal avant de transmettre sur ses sorties le paquet de données aux modules voisins suivants, où :
   Tavance ≤ P + δ, avec
   δ le temps de décalage entre le cycle du module et le cycle du module voisin précédent, où δ ≤ ε + γ.

On parle alors d'un fonctionnement localement synchrone avec contrôle de gigue, à favoriser pour un fonctionnement optimisé après démarrage.

En outre, il est avantageux que la seconde phase d'exécution de l'algorithme de pilotage mette en oeuvre un protocole de routage des données, dans lequel durant chaque cycle les paquets de données échangés entre deux modules voisins sont découpées et envoyées en plusieurs groupes répartis sur des intervalles de temps supérieurs à un temps de décalage de la propagation entre deux modules voisins de rang n et n+1 respectivement, de sorte que chaque octet d'un groupe d'ordre NO est reçu sur un connecteur avant l'envoi de l'octet correspondant d'un groupe d'ordre supérieur NO+1 sur un autre connecteur.

D'autres caractéristiques et avantages de la présente invention apparaîtront à la lecture de la description détaillée ci-après, d'exemples de mise en oeuvre non limitatifs, faite en référence aux figures annexées dans lesquelles :
- la figure 1 est une vue schématique d'un premier module conforme à l'invention ;
- les figures 2a et 2b sont des vues schématiques d'un deuxième module conforme à l'invention, respectivement vue de dessous et de dessus ;
- la figure 3 est une vue schématique d'un troisième module conforme à l'invention ;
- la figure 4 est une vue schématique d'un quatrième module conforme à l'invention ;
- la figure 5 est une vue schématique d'une installation conforme à l'invention intégrant plusieurs modules de la figure 1 interconnectés ;
- la figure 6 est une vue schématique d'une installation conforme à l'invention intégrant plusieurs modules de la figure 3 interconnectés ;
- la figure 7 est une vue schématique d'une installation conforme à l'invention intégrant plusieurs modules des figures 3 et 4 interconnectés ;
- la figure 8 est une vue schématique partielle d'une installation conforme à l'invention intégrant plusieurs modules de la figure 1 interconnectés, illustrant la numérotation des connecteurs des modules ;
- les figures 9 et 10 sont des vues schématiques partielles de l'installation de la figure 8, avec une illustration des communications entre un module central et ses modules voisins de rangs 1 et 2 ;
- les figures 11a à 11d sont des vues schématiques de la propagation d'un signal de synchronisation dans une installation du type de la figure 8;
- les figures 12a à 12c sont des vues schématiques des données communiquées entre modules dans un mode communication basé sur une seule source de rythme et sans contrôle de gigue ;
- la figure 13 est une vue schématique des étapes de calcul mises en oeuvre de manière périodique par le contrôleur d'un module durant la phase d'exécution du programme, selon une hypothèse synchrone ;
- la figure 14 est une vue schématique de la mise en oeuvre d'un protocole de routage.

La première partie de la description porte sur la réalisation d'un module 1 conforme à l'invention. Le module 1 est un module programmable, autrement dit conçu pour être piloté par un programme informatique ou algorithme de pilotage, qui est destiné à former un élément unitaire et démontable d'une installation IN modulaire.

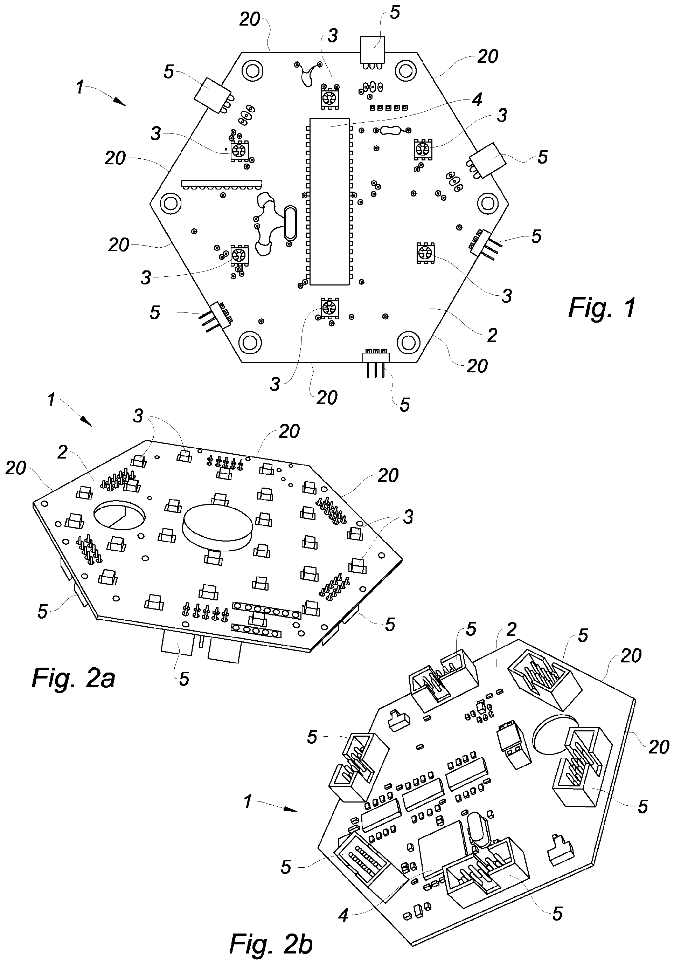

Les figures 1 à 4 illustrent quatre modes de réalisation d'un module 1 ; les mêmes références numériques seront employées pour décrire les éléments ou organes similaires, identiques ou présentant les mêmes fonctionnalités.

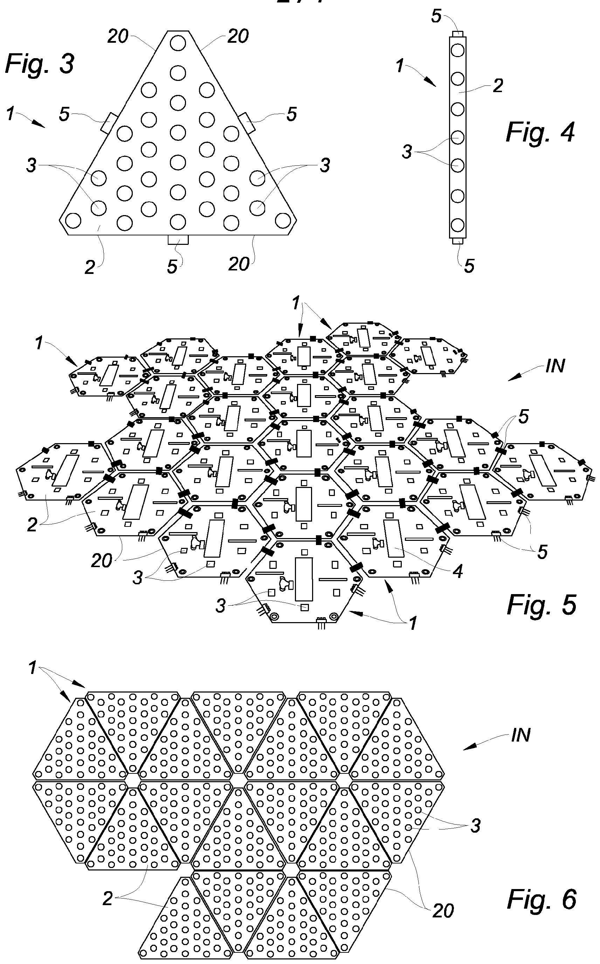

De manière générale, un module 1 comporte une embase 2 de support, réalisée de préférence dans un matériau rigide, présentant une forme polygonale délimitée par des arêtes 20. Dans l'exemple des figures 1 et 2 l'embase 2 présente une forme hexagonale délimitée par six arêtes, dans l'exemple de la figure 3 l'embase 2 présente une forme triangulaire équilatérale délimitée par trois arêtes et dans l'exemple de la figure 4 l'embase 2 présente une forme rectangulaire délimitée par quatre arêtes. Il est bien entendu envisageable de prévoir une embase avec une forme de carrée, de losange, de triangle rectangle, etc. Cette embase 2 sert de support physique aux différents organes décrits ci-après.

Le module 1 comporte également au moins un émetteur de signaux 3 fixé sur l'embase 2, et en particulier plusieurs émetteurs de signaux 3. Pour la suite de la description, l'émetteur de signaux 3 est du type émetteur de signaux lumineux, notamment du type diode électroluminescente. Ainsi, on parle d'un module 1 lumineux et d'une installation IN lumineuse. Dans l'exemple de la figure 1 le module 1 comporte six diodes électroluminescentes 3, dans l'exemple de la figure 2 le module 1 comporte vingt sept diodes électroluminescentes 3, dans l'exemple de la figure 3 le module 1 comporte trente et une diodes électroluminescentes 3, et dans l'exemple de la figure 4 le module 1 comporte sept diodes électroluminescentes 3. Il est bien entendu envisageable que l'émetteur de signaux soit d'un autre type, tel qu'un émetteur de signaux sonores, tout comme il est envisageable de réunir sur un même module 1 au moins deux types distincts d'émetteurs de signaux.

Le module 1 comporte en outre au moins un capteur de mesure (non illustré) d'un paramètre local fixé sur l'embase 2, le ou chaque capteur générant des données de mesure locale. A titre d'exemple, le capteur peut être du type capteur de proximité - autrement appelé détecteur de présence - qui peut être du type capacitif ou inductif, ou capteur de pression, ou capteur de température, ou capteur de luminosité, etc. Le rôle du capteur est de mesuré un paramètre (proximité ou présence d'une personne ou d'un objet, température, pression, luminosité, etc.) dans l'environnement local du module 1.

Le module 1 intègre également au moins un contrôleur 4 fixé sur l'embase 2, notamment du type micro-contrôleur. Ce contrôleur 4 est relié :
- au ou à chaque émetteur de signaux 3 pour piloter l'émission des signaux par l'émetteur concerné ; et
- au ou à chaque capteur pour recevoir ces données de mesure locale.

Le module 1 intègre aussi au moins deux connecteurs 5 fixés sur les arêtes 20 de l'embase et reliés au contrôleur 4. Chaque connecteur 5 présente :
- une interface d'alimentation électrique du ou des émetteurs de signaux 3 et du contrôleur 4 ; et
- une interface de communication bidirectionnelle raccordée au contrôleur 4 et présentant une entrée de communication et une sortie de communication.

Chaque connecteur 5 d'un module 1 est conformé pour être connecté physiquement avec un connecteur 5 d'un module voisin 1 (si un tel module voisin est bien entendu présent) dans l'installation IN modulaire pour permettre :
- une communication bidirectionnelle entre le contrôleur du module 1 et le contrôleur du module voisin 1 (autrement dit la transmission de données dans les deux sens entre les deux contrôleurs), où l'entrée de communication d'un connecteur est connectée à la sortie de communication de l'autre connecteur 5, et inversement ; et
- une distribution de l'alimentation électrique entre les modules 1.

Pour la suite, on entend par modules voisins, deux modules 1 qui présentent des arêtes 20 adjacentes, voire jointives ; la connexion entre les deux modules 1 se faisant avec les connecteurs 5 placés sur ces arêtes 20 jointives.

Pour connecter deux connecteurs 5 de modules voisins 1, deux configurations sont envisageables : configuration symétrique et configuration asymétrique.

Dans la configuration asymétrique, les deux connecteurs sont asymétriques, avec un connecteur 5 présentant une connectique mâle et l'autre connecteur 5 présentant une connectique femelle, pour une connexion mâle-femelle entre les deux connecteurs 5. Il est donc nécessaire, pour réaliser l'installation IN, de toujours prévoir un connecteur mâle en face d'un connecteur femelle. A ce titre, il est avantageux de prévoir pour chaque module 1 autant de connecteur mâle que de connecteur femelle, et d'orienter correctement chaque module 1 dans l'installation pour faire coïncider connecteur mâle et connecteur femelle. Dans l'exemple de la figure 1, le module 1 présente trois connecteurs 5 mâles et trois connecteurs 5 femelles.

Dans la configuration symétrique, les deux connecteurs 5 sont symétriques. Ainsi, chaque connecteur 5 peut être relié à n'importe quel connecteur du module 1 voisin, tout en assurant la liaison électrique et la communication. Pour assurer la liaison électrique, il est nécessaire qu'une fiche d'un connecteur soit liée à une fiche de l'autre connecteur avec la même tension (par exemple, la masse et la tension d'alimentation). Pour la liaison de communication, il est nécessaire que la sortie de communication d'un connecteur soit liée à l'entrée de communication de l'autre connecteur, et inversement.

Deux modes de réalisation sont ainsi envisageables pour cette configuration symétrique :
- une connexion physique directe entre les deux connecteurs, en employant des connecteurs qui sont mâle-femelle des deux cotés ; ou
- une connexion physique indirecte entre les deux connecteurs, en employant un câble intermédiaire qui relie les deux connecteurs entre eux.

Dans le cas d'une connexion physique indirecte, le câble doit être symétrique et les connecteurs sont tous les deux mâles (ou tous les deux femelles) tandis que le câble présente deux interfaces opposées femelles (ou mâles). Dans l'exemple des figures 2a et 2b, tous les connecteurs 5 sont du type femelle, et sont prévus pour être connectés à des connecteurs 5 également femelles de modules 1 voisins au moyen de câbles.

A titre d'exemple, chaque connecteur forme une interface de communication bidirectionnelle supportant le mode UART, bien adapté à l'utilisation du module 1, bien que d'autres modes puissent éventuellement être envisagés.

Pour pouvoir réaliser une installation 1 sans trou, autrement dit où chaque module 1 est connecté à tous ses modules 1 voisins et où les embases 2 des modules 1 sont disposées de manière jointive, avec les arêtes jointives entre deux modules 1 voisins, il est préférable que le module 1 comporte un connecteur 5 sur chaque arête 20, ce qui est le cas des modules 1 des figures 1, 2 et 3.

Par contre, le module 1 de la figure 4 présente uniquement deux connecteurs 5 (contre quatre arêtes), qui sont positionnés sur les arêtes opposées les plus courtes de l'embase 2.

Les figures 5 et 6 illustre des installations IN composées de plusieurs modules 1 interconnectés et identiques, avec respectivement des modules hexagonaux conformes à la figure 1 et des modules triangulaires conformes à la figure 3. Dans ces installations IN, les modules 1 sont répartis selon un pavage planaire avec leurs embases disposées de manière jointive, sans vide et sans empiétement, et chaque module 1 est connecté à son ou ses modules voisins par leurs connecteurs 5 respectifs. Il est cependant envisageable de prévoir un ou plusieurs trous dans l'installation IN, en se passant d'un ou plusieurs modules 1 dans le pavage.

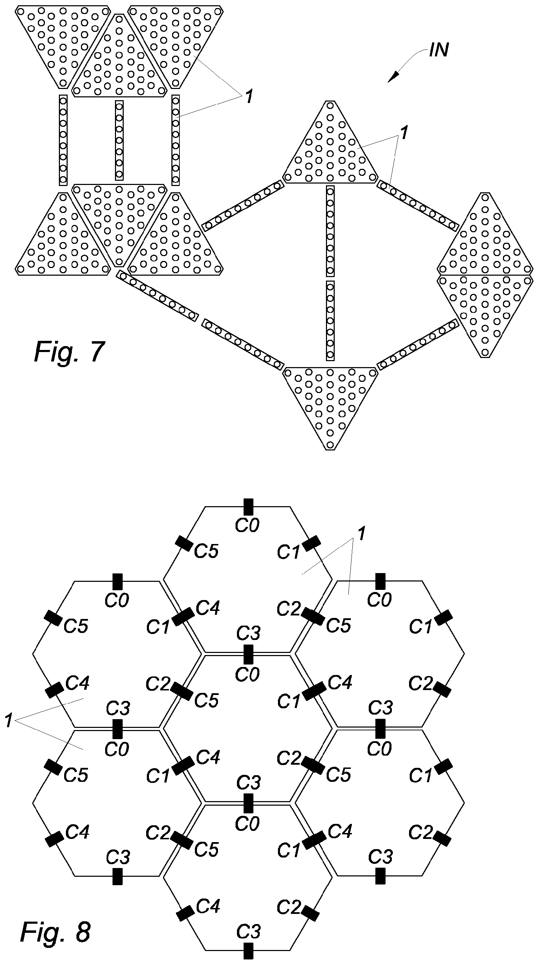

La figure 7 illustre une installation IN composé de plusieurs modules 1 interconnectés, avec à la fois des modules triangulaires conformes à la figure 3 et des modules rectangulaires conformes à la figure 4. Dans cette installation IN, les embases de certains modules 1 sont parfois écartées des embases de modules voisins avec lesquels ils sont connectés. En outre, les modules triangulaires présentent également des connecteurs (non illustrés) à leurs sommets respectifs, pour pouvoir connecter des modules rectangulaires sur les sommets des modules triangulaires.

De manière générale, il est bien entendu possible de prévoir un connecteur sur tout ou partie des sommets des embases des modules, pour multiplier les possibilités de configuration géométrique de l'installation ; l'embase 2 étant ainsi délimitée par des arêtes et des sommets (ou coins).

Il est également envisageable de réaliser une installation volumique, et non pas uniquement planaire, en répartissant les modules selon un pavage volumique.

La suite de la description porte sur le procédé de pilotage d'une installation IN modulaire tel que décrite ci-dessus.

Dans l'installation IN, les modules 1 peuvent communiquer avec des modules voisins dans les deux sens et le procédé de pilotage exploite cette caractéristique pour mettre en oeuvre un pilotage quasi synchrone entre modules voisins où chaque module 1 exécute le même programme dans un mode de programmation pseudo-parallèle. Ainsi, chaque module exécute le même programme d'une manière cyclique périodique et synchrone de la manière suivante : à chaque cycle, chaque module établit une communication bidirectionnelle avec le ou les modules voisins et exécute un ou plusieurs algorithmes du programme.

Le procédé commence par une phase préalable d'entrée d'un algorithme de pilotage au contrôleur 4 d'au moins un module 1 dit maître, sous la forme de trames de données répartis dans des cycles périodiques successifs, les autres modules 1 étant dits esclaves. Ensuite, le procédé consiste en ce que chaque module exécute le même programme d'une manière cyclique périodique et synchrone, qui se décompose comme suit :
- une première phase d'exécution d'un algorithme de distribution dans lequel des trames de données de l'algorithme de pilotage sont distribuées de manière synchrone et périodique, de proche en proche entre les modules 1 en partant d'un au moins un module 1 dit maître ;
- une fois que l'algorithme de pilotage distribué est complètement chargé dans tous les contrôleurs 4, une seconde phase d'exécution de l'algorithme de pilotage par chaque contrôleur 4 de manière synchrone et périodique.

La première phase et la deuxième phase constituent toutes les deux des phases d'exécution du même programme par l'ensemble des contrôleurs, où :
- dans la première phase, chaque contrôleur exécute un premier algorithme, dit algorithme de distribution, qui a été préalablement chargée dans une mémoire non volatile (mémoire ROM ou mémoire flash) de chaque contrôleur, de sorte qu'au démarrage de l'installation (autrement dit à la mise en tension électrique), chaque contrôleur est prêt à lancer cette première phase ;
- dans la seconde phase, chaque contrôleur exécute l'algorithme de pilotage préalablement distribué durant la première phase, où chaque contrôleur démarre en même temps cette seconde phase qui consistera pour l'essentiel à piloter les émetteurs de signaux, et où l'algorithme de pilotage aura été stockée dans une mémoire volatile de chaque contrôleur, afin de pouvoir distribuer un nouvel algorithme de pilotage si l'on souhaite modifier le pilotage des émetteurs de signaux.

Concernant la phase d'entrée, il est envisageable de connecter le module maître à une source externe, tel qu'un terminal informatique, qui enverra les trames de données au contrôleur du module maître. Il est également envisageable d'employer, d'une part, une unité amovible de stockage de données numériques (telle qu'une carte mémoire) pour stocker l'algorithme de pilotage et, d'autre part, un lecteur fixé sur le module maître et conçu pour lire les données stockées dans ladite unité de stockage afin de faire exécuter le programme par le contrôleur du module maître.

Il est à noter que la phase d'entrée de l'algorithme de pilotage et la première phase d'exécution de l'algorithme de distribution (ou phase de distribution) sont réalisées :
- soit de manière séquentielle, où la première phase débute une fois que l'algorithme de pilotage est complètement chargé dans le contrôleur du au moins un module maître ;
- soit de manière parallèle, où chaque contrôleur d'un module reçoit dans un cycle courant une trame de données de l'algorithme de pilotage et la propage au(x) contrôleur(s) du ou des modules voisins dans le cycle suivant.

La particularité du procédé réside notamment dans les deux phases suivantes :
- la première phase qui se rapporte à la distribution de module en module voisin d'un algorithme de pilotage distribué, par l'exécution d'un algorithme de distribution, notamment du type chargeur d'amorçage ou « bootloader », qui va propager l'algorithme de pilotage à partir d'une ou plusieurs sources ;
- la seconde phase qui se rapporte à un fonctionnement quasi synchrone entre modules voisins, par l'exécution du ou des algorithmes de pilotage distribués synchrones.

Un premier avantage de l'installation IN est son caractère totalement « scalable », c'est-à-dire qu'elle offre la possibilité d'ajouter autant de modules que l'on souhaite et ainsi de réaliser une installation de taille arbitraire. Concernant le procédé de pilotage, plus il y a de modules et plus il y a de contrôleurs pour exécuter le ou les algorithmes de pilotage en parallèle ; seul le temps de la distribution de l'algorithme va cependant augmenter avec le nombre de modules. En deuxième avantage, installation IN ne nécessite pas de bus centralisé de communication, puisque la communication est locale entre modules voisins et, encore une fois, plus l'installation IN intègre de modules 1 et plus il y aura des canaux locaux de communication. Un troisième avantage est de permettre la programmation avec un modèle de machine virtuelle (code octet) qui est interprété par chaque contrôleur de module, et qui est donc indépendant de l'architecture de l'installation.

La suite de la description porte sur plusieurs aspects relatifs à ce procédé de pilotage qui est assimilé à de la programmation cellulaire qui combine de la programmation synchrone durant la phase d'exécution (via notamment des coroutines synchrones) avec de la programmation distribuée synchrone durant la première phase de distribution, tout en donnant éventuellement un sens géométrique aux liaisons entre les modules 1 dans l'installation IN.

Dans une telle installation IN, chaque module 1 est lié à son ou ses modules voisins 1 par des interfaces de communication, et la programmation cellulaire se base sur les hypothèses suivantes :
- l'installation IN fonctionne comme un réseau qui opère d'une manière quasi-synchrone, de qui implique un cycle ou temps logique ;
- chaque module 1 exécute le même programme au même rythme synchrone ;
- chaque module 1 ne voit directement que ses propres variables ;
- la communication entre modules 1 se fait par propagation de valeurs de certaines variables, où les valeurs sont propagées avec un cycle de retard.

Pour la programmation, on peut comprendre chaque variable comme un tableau indexé par le module 1, mais dont l'accès est local et uniquement réservé au module 1 concerné : un module Mi peut accéder à son propre tableau de variable x[i], mais il ne peut pas accéder directement aux tableaux de variables x[j] des autres modules Mj (j ≠ i).

Un premier aspect concerne la mise en oeuvre de la première phase de distribution.

L'intérêt de la programmation cellulaire décrite ci-dessus est de combiner la distribution d'algorithmes de pilotage et la programmation synchrone. Dans le procédé de pilotage, deux données sont essentielles pour régir une telle programmation cellulaire :
- le fonctionnement est cyclique, périodique et synchrone ;
- la communication se fait par propagation de valeurs de variables.

Pour faciliter la synchronisation entre les modules, un module dit maître constitue une source unique du rythme périodique en génèrant un signal de synchronisation (parfois appelé « Sync ») qui est propagé de proche en proche entre les modules en partant du module maître via leurs connecteurs respectifs.

Pour la suite de la description, la troisième donnée suivante est également retenue : les canaux sont numérotés en cohérence avec l'orientation du module 1 dans l'installation, et on parle alors d'algorithmes géométriques qui feront l'objet d'une description ultérieure.

La première phase de distribution des algorithmes de pilotage distribués dépend en outre des aspects supplémentaires suivants :
- les algorithmes sont prévus pour des réseaux statiques ;
- la présence d'un module maître ;
- les dimensions de l'installation.

Pour la première phase de distribution, le procédé peut prévoir de mettre en oeuvre, une distribution par vague dans laquelle, en partant d'un ou de plusieurs initiateurs (modules maître), la propagation des trames de données traverse l'installation comme une vague à la vitesse du médium, à savoir un module par cycle, où :
- le ou les modules maître déclenchent la vague par l'envoi des trames de données ;
- les modules esclaves attendent et écoutent de recevoir ces trames de données et les propagent, avec un cycle de retard, aux modules voisins.

Autrement dit, lors de la première phase de distribution, à chaque cycle, le contrôleur 4 de chaque module 1 réalise les opérations suivantes :
- réception d'un signal de synchronisation sur au moins une entrée de communication, et transmission du signal de synchronisation sur les sorties de communication ;
- écoute sur toutes les entrées de communication du module 1 ;
- réception d'une trame de données de l'algorithme de pilotage sur au moins une entrée de communication du module, la trame de données correspondant à une trame de données transmise lors du cycle précédent par un module voisin sur la sortie de communication connectée à cette entrée de communication du module ;
- stockage de la trame de données dans le contrôleur ;
- transmission de la trame de données sur les sorties de communication à destination des modules voisins.

Cette distribution par vague permet avantageusement de résoudre deux problématiques liées à la programmation distribuée :
- informer tous les modules (problématique du « broadcast ») ; et
- combiner une information distribuée (problématique du « mergecast »).

Dans tous les cas, la première phase de distribution nécessite de prendre en considération les dimensions de l'installation IN, pour répondre à la question de la terminaison de la propagation ; cette terminaison correspondant au moment où le procédé peut arrêter de propager une vague car il est certain que la vague a traversé l'installation IN entière et a atteint tous les modules 1.

Il est donc avantageux que la première phase de distribution soit précédée d'une phase de détermination d'une distance maximale Dmax correspondant à la plus grande distance entre le module maître et le ou les modules esclaves les plus éloignés dans l'installation IN en cheminant de module voisin en module voisin selon le ou les chemins les plus courts, pour établir le temps nécessaire à la phase de distribution pour que l'algorithme de pilotage distribué soit complètement chargé dans tous les contrôleurs 4.

Pour plus de clarté, il est important de définir les notions géométriques suivantes, en considérant l'installation IN comme un réseau constitué de noeuds (les modules) et de canaux (les liaisons directes entre modules voisins, qui sont pour rappel réalisés au moyen des connecteurs 5) :
- un chemin est une suite de modules M0, M1, ..., Mk tels que chaque module Mi est lié par un canal au module voisin Mi+1 ;
- la longueur d'un chemin M0, M1, ..., Mk est k, le nombre de canaux à traverser ;
- la distance entre deux modules est la longueur du ou des plus court(s) chemin(s) reliant deux modules entre eux ;
- le diamètre de l'installation correspond à la plus grande distance entre deux de ses modules ;
- la distance maximale Dmax correspond à la plus grande distance entre le module maître et un module esclave.

Pour un réseau connexe, chaque distance est finie et pour un réseau fini connexe, son diamètre est fini.

Si l'on connaît une borne supérieure b pour le diamètre et si l'on itère un algorithme à vague b fois, alors il est certain que la vague aura traversé l'installation entière, car le diamètre est supérieur ou égal à la distance maximale Dmax.

La phase de détermination de la distance maximale Dmax peut être réalisée de deux manières :
- première manière : en établissant la topologie de l'installation ;
- seconde manière : en faisant circuler, de proche en proche entre les modules, une fonction d'estimation de la distance maximale Dmax qui évolue au fur et à mesure de sa propagation dans l'installation jusqu'à atteindre un maximum correspondant à la distance maximale.

Concernant la seconde manière, il est envisageable en procédant, à partir du module maître, à la propagation par vague d'une fonction d'estimation où :
- initialement, la distance maximale est supposée égale à zéro ;
- puis, à chaque cycle de la vague, chaque module communique la plus grande distance connue à ses voisins incrémentée de 1, puis la combine avec l'opérateur max avec les valeurs de distance que les voisins connaissent.

Les deux informations suivantes pour chaque module permettent une synchronisation globale de l'installation :
- la propre distance Di du module Mi vis-à-vis du module maître ; et
- la distance maximale Dmax entre le module maître et le ou les modules esclaves les plus éloignés.

En effet, lorsque le module maître déclenche une vague, un module Mn la reçoit n cycles plus tard. D'un autre coté, tous les modules partagent l'information, que les derniers modules recevront à temps m à partir du déclenchement. Vue d'un module Mn de distance n, les derniers modules recevront la vague (m - n) cycles plus tard. Il suffit alors que chaque module Mn de distance n attende (m - n) cycles après la réception de la vague afin que tous les modules puissent entrer au même cycle dans un état souhaité ; permettant ainsi de synchroniser tous les modules de manière globale. Autrement dit, chaque module peut posséder son propre compteur (en fonction de sa propre distance au module maître) qui décrémente à chaque nouveau cycle pendant la première phase, jusqu'à atteindre zéro (tous les compteurs atteignant zéro en même temps) pour que tous les modules démarrent en même temps la seconde phase.

Pour la première phase de distribution, il est également envisageable de procéder selon une approche dite de l'arbre de recouvrement pour optimiser la propagation.

Alors que les premières vagues visent à inonder l'installation d'informations (le ou les algorithmes distribués), il est possible d'optimiser l'utilisation de la bande passante pour des vagues ultérieures. A ce titre, lors d'une vague de propagation de distances à partir du module maître, chaque module Mn recevra d'un ou de plusieurs voisins Mn-1 de distance (n - 1) sa distance n. Ce module Mn peut alors choisir un de ces voisins comme « parent », tandis que le parent peut être notifié qu'il a un « enfant ». La relation « parent- enfant » ainsi définie permet de constituer un arbre de recouvrement avec le module maître à la racine et les modules les plus distants aux extrémités.

Une fois qu'un arbre de recouvrement est établi, le procédé peut alors restreindre la propagation des vagues entre le module maître et l'ensemble des modules à des liens de l'arbre de recouvrement, libérant ainsi des canaux de communication entre modules voisins pour d'éventuels autres usages.

La suite de la description porte sur une méthode de réalisation de la première phase de distribution, en employant un programme d'amorçage (autrement appelé chargeur d'amorçage ou « bootlader ») préalablement chargé dans les mémoires non volatiles (type ROM ou flash) des contrôleurs.

Un programme d'amorçage est un programme relativement petit en taille qui permet l'installation et l'exécution d'une application. La difficulté dans l'installation 1 modulaire, qui pour rappel consiste en un réseau de contrôleurs interconnectés, est de mettre à jour le programme interne (« firmware ») dans chaque contrôleur. Comme expliqué ci-dessus, cette mise à jour est réalisée selon une approche d'algorithmes distribués, en employant ici un programme d'amorçage distribué et très efficace, car économe en taille et rapide en exécution.

Pour la suite, nous considérerons que chaque contrôleur présente un modèle d'architecture mémoire adapté pour :
- exécuter de la mémoire non volatile et de la mémoire vive ;
- programmer la mémoire non volatile par logiciel ;
- protéger une partie de la mémoire non volatile contre cette programmation.

Pour proposer un programme d'amorçage (appelé parfois « stage0 ») de taille minimale et immuable, qui permet la programmation distribuée sur tout le réseau de contrôleur, le programme d'amorçage« stage0 » doit présenter certaines caractéristiques, à savoir :
- le programme d'amorçage « stage0 » de taille minimale et immuable a pour tâche de déployer et d'exécuter un programme dans la mémoire vive de chaque contrôleur du réseau ;
- le programme d'amorçage « stage0 » peut déployer en tant que programme un autre programme d'amorçage appelé « stage1 » de taille moyenne (ie. supérieure à la taille du programme d'amorçage « stage0 ») qui peut être plus efficace, plus complexe et qui peut déployer une application dans la mémoire flash mutable de chaque contrôleur ;
- le programme d'amorçage « stage0 » doit également permettre de lancer une application déjà déployée dans la mémoire flash de chaque contrôleur, notamment en déployant un logiciel de taille minimale qui réalise un saut vers l'adresse de l'application.

Le fonctionnement du programme d'amorçage « stage0 » est immuable sur le principe, dans le sens où un changement du programme d'amorçage « stage0 » n'est possible qu'en reprogrammant individuellement chaque contrôleur, alors qu'un changement du programme d'amorçage « stage1 » ne nécessite aucune intervention physique ou manuelle.

Pour le déploiement (ou la distribution) d'un algorithme de pilotage dans la mémoire vive de chaque contrôleur, et pour son lancement (ou exécution) quasi synchrone par chaque contrôleur, les étapes suivantes (a) à (I) sont mises en oeuvre :
Etape (a) : Le programme d'amorçage « stage0 » est déclenché par coupure et rétablissement de l'alimentation électrique, en paramétrant les contrôleurs de sorte qu'une coupure et un rétablissement de l'alimentation électrique conduisent nécessairement à l'exécution du programme d'amorçage « stage0 » et tous les contrôleurs entrent d'une manière asynchrone dans un état d'attente.
Etape (b) : Chaque contrôleur de module repère la présence des modules voisins connectés, autrement dit détecte la connexion de chacun de ses connecteurs avec un connecteur d'un module voisin.
   A titre d'exemple, il est envisageable de procéder comme suit : sur chacun de ses connecteurs, chaque contrôleur met les sorties de communication dans un état « 1 » et les entrées de communication en mode entrée avec pull-up, c'est-à-dire que l'entrée de communication lit et récupère l'état de la sortie de communication du module voisin qui lui est connectée. Ainsi, il y deux possibilités :
   - si l'entrée de communication est connectée à une sortie de communication (autrement dit si le connecteur concerné est connecté au connecteur d'un module voisin), alors cette entrée de communication lit et récupère l'état « 1 » qui est l'état de la sortie de communication ;
   - si l'entrée de communication n'est pas connectée à une sortie de communication (autrement dit le connecteur concerné est connecté à aucun autre connecteur), alors cette entrée de communication est mise à l'état « 0 » ;
Etape (c) : Après un intervalle de temps déterminé d1, tout connecteur détecté comme étant non connecté avec un module voisin est bloqué et marqué comme défectueux.
   En poursuivant avec l'exemple ci-dessus, toute entrée de communication lue dans un état « 0 » est bloquée et marquée comme étant défectueuse.
Etape (d) : Après un intervalle de temps déterminé d2, chaque contrôleur de module se met en mode d'écoute et de propagation du signal de synchronisation « Sync ».
Etape (e) : Après un intervalle de temps déterminé d3, le module maître commence à émettre un signal de synchronisation «Sync» périodique d'une période P.
Etape (f) : Chaque contrôleur de module qui attend le signal de synchronisation « Sync » le reçoit et le propage à ses voisins avec un décalage temporel compris entre ε et (ε + γ), où :
   - ε est le temps de propagation minimal entre le contrôleur d'un module et le contrôleur d'un module voisin suivant ; et
   - γ la gigue du cycle ou gigue de propagation.
Etape (g) : Ensuite, chaque contrôleur de module se met en mode réception sur les entrées de communication de ses connecteurs, et attend un intervalle de temps déterminé d4, où d4 ≥ (ε + γ), avant de se mettre à transmettre des données.
Etape (h) : Entre chaque transmission d'un octet, un intervalle d'attente d5 est inséré pour s'assurer que la transmission par un module soit plus lente que la réception par un module voisin.
Etape (i) : Chaque octet peut éventuellement est transmis au moins deux fois, par exemple trois fois. À la réception, le contrôleur décide sur l'octet à reconstruire par majorité bit par bit. La probabilité d'erreur de transmission peut être contrôlée par la vitesse.
Etape (j) : Un protocole asymétrique entre le module maître et les modules esclaves permet d'établir :
   - Pour tout module, sa distance avec le module maître et avec un module voisin plus proche du module maître ;
   - Pour tout module, les modules distants les plus éloignés du module maître dont les chemins les plus courts passent par lui, établissant ainsi la distance la plus grande entre le module maître et le module le plus éloigné du module maître ;
   - le nombre de cycles à attendre NAT pour que l'algorithme de pilotage soit chargé dans tous les contrôleurs, autrement dit le nombre de cycle avant le saut vers l'exécution synchrone de cet algorithme de pilotage.
Etape (k) : Ensuite, le code de l'algorithme de pilotage est transmis avec des paramètres de longueur, éventuellement d'adresse cible, et, en dernier paramètre, le nombre de cycles à attendre NAT. Dans chaque contrôleur, ce nombre de cycles fait l'objet d'un compteur qui est décrémenté lors de la propagation, puis décrémenté à chaque cycle. Par conséquent, ce compteur arrive à « 0 » au même cycle pour chaque module.
Etape (I) : Lorsque le compteur arrive à zéro, le saut vers le code transmis est réalisé et tous les contrôleurs démarrent en même temps l'exécution de l'algorithme de pilotage (autrement dit la seconde phase).

Il est envisageable d'intercaler, entre la première phase et la seconde phase, une phase de contrôle du chargement de l'algorithme de distribution dans chaque module. Cette phase de contrôle peut se présenter sous la forme d'une fonction de contrôle distribué sur l'ensemble des modules, chaque contrôleur exécutant cette fonction de contrôle, puis renvoyant le résultat du contrôle au module maître. Si un module présente un défaut de chargement de l'algorithme de pilotage, alors on recommence totalement la première phase de distribution.

Un second aspect concerne la mise en oeuvre d'une programmation synchrone dans la seconde phase d'exécution du procédé.

Le coeur de cette programmation synchrone repose sur un langage de programmation synchrone qui assure notamment le contrôle des émetteurs de signaux 3, la communication des contrôleurs 4 avec les contrôleurs 4 des modules 1 voisins, la lecture du ou des capteurs équipant les modules 1, l'écoute sur le canal de communication (ou « broadcast »).

La programmation synchrone est aussi parallèle sur un même module 1 ce qui permet de réaliser plusieurs fonctions en temps réel de manière indépendante, à titre d'exemple la communication entre modules 1 voisins peut être conçue comme une communication parallèle sur plusieurs canaux virtuels. Ainsi, plusieurs algorithmes distribués peuvent être exécutées en parallèle par chaque contrôleur 4.

Un avantage de cette solution est d'offrir un environnement de développement intégré avec un simulateur en temps réel qui permet de développer et de simuler des programmes sur un ordinateur sans avoir accès à l'installation réelle.

L'installation IN se rapproche d'un système réactif synchrone qui interagit avec un environnement grâce aux capteurs équipant les modules 1 et grâce aux lectures des données issues des modules 1 voisins. Un programme synchrone utilise des flots ou paquets de données synchrones, conduits par un certain rythme généralement appelé « cycle », « temps logique » ou « tick », qui relient chaque module 1 et son environnement (modules voisins et capteurs).

Un programme synchrone passe alors, pour chaque module 1, quatre étapes essentielles lors d'un temps logique :
e1) échantillonnage/communication des signaux de sortie ;
e2) lecture des signaux d'entrée ;
e3) calcul d'une réponse et mise à jour de l'état du module (autrement dit mise à jour de ses variables internes) ;
e4) écriture des signaux de sortie ;
La causalité veut que, pour un cycle ou temps logique, l'étape e4) d'écriture des signaux de sortie se fasse après l'étape e2) de lecture des signaux d'entrée. En contrepartie, l'étape e4) d'écriture des signaux de sortie d'un cycle courant se fera avant l'étape e2) de lecture des signaux d'entrée du cycle suivant.

En pratique, le cycle ou temps logique suit un régime périodique, par exemple un cycle toutes les 10 millisecondes ou toutes les millisecondes, etc. ; la période d'échantillonnage dépendant de l'application recherchée.

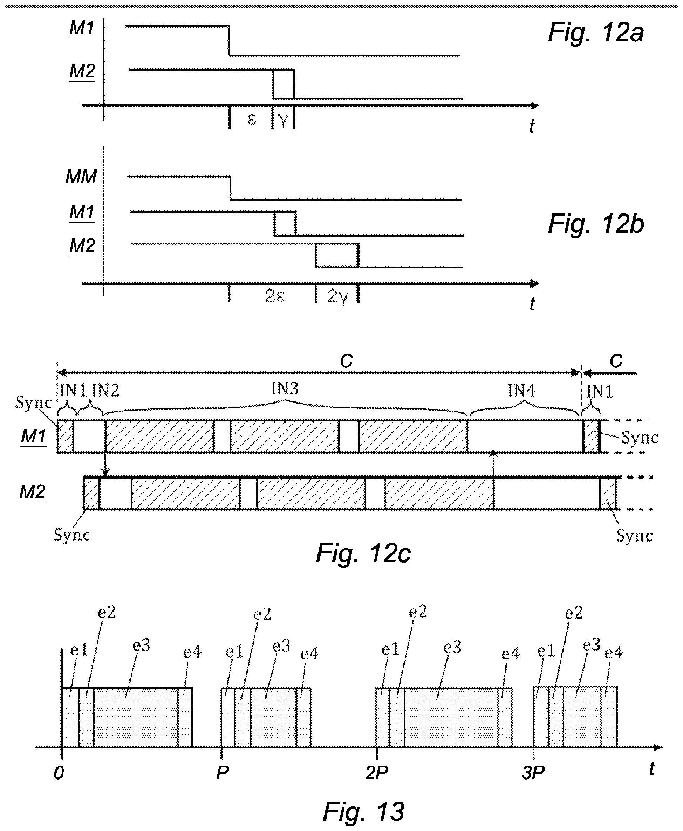

La figure 13 illustre ainsi le fonctionnement d'un contrôleur d'un module, selon une hypothèse synchrone, dans lequel le contrôleur réalise successivement les étapes de calcul suivantes à chaque période P :
- étape e1) d'échantillonnage/communication des signaux de sortie ;
- étape e2) lecture des signaux d'entrée (comprenant notamment les données de mesure et les données lues sur les entrées de communication des connecteurs) ;
- étape e3) de calcul d'une réponse et de mise à jour de l'état du module ;
- étape e4) d'écriture des signaux de sortie.

En d'autres termes, lors de la seconde phase d'exécution, à chaque cycle, le contrôleur 4 de chaque module 1 réalise les opérations suivantes :
- réception d'un signal de synchronisation sur au moins une entrée de communication, et transmission du signal de synchronisation sur les sorties de communication ;
- écoute sur toutes les entrées de communication du module (opération d'écoute dans l'attente de recevoir des données en provenance des modules voisins) ;
- lecture des données de mesure issues du ou des capteurs équipant le module (une partie de l'étape e2) de lecture des signaux d'entrée) ;
- lecture de variables dites d'état représentatives de l'état du module, notamment de l'état du au moins un émetteur de signaux (une autre partie de l'étape e2) de lecture des signaux d'entrée) ;
- lecture (ou réception) d'un paquet de données dit entrant sur au moins une entrée de communication du module, ledit paquet de données intégrant au moins une variable d'entrée pour l'exécution de l'algorithme de pilotage (une autre partie de l'étape e2) de lecture des signaux d'entrée) ;
- exécution de l'algorithme de pilotage avec en entrée la ou les variables d'entrée du ou des paquets de données reçus dans le cycle courant, les données de mesure et les variables d'état, et en sortie des instructions de pilotage du ou des émetteurs de signaux du module, une mise à jour des variables d'état (équivalent à l'étape e3) de calcul d'une réponse et de mise à jour), et le calcul de variables de sortie associées à chaque sortie de communication (équivalent à l'étape e4) d'écriture des signaux de sortie) ;
- transmission sur chaque sortie de communication d'un paquet de donnée dit sortant intégrant les variables de sortie associées à chaque sortie de communication (équivalent à l'étape e1) d'échantillonnage/communication des signaux de sortie).

Ainsi, l'algorithme de pilotage exécuté par le contrôleur de chaque module travaille avec en entrée les signaux d'entrée suivants :
- les données de mesure issues du ou des capteurs intégrés au module ;
- les variables d'état représentatives de l'état du module dont l'état du ou des émetteurs de signaux intégrés au module ;
- les variables d'entrée (autrement appelées paquet de données entrant) qui correspondent aux données entrant sur les entrées de communication du module.

En pratique, le module peut être représenté par des variables qui lui sont propres, à savoir des variables locales comprenant :
- les variables d'entrée qui ne dépendent pas du module, mais dont les valeurs viennent des modules voisins ;
- les données de mesure ;
- les variables d'état ; et
- les variables de sortie (autrement appelées paquet de données sortant) que le contrôleur du module modifie pour communiquer avec les modules voisins.

Il est ainsi important qu'un module puisse mémoriser ses variables locales, et d'éventuelles autres informations, pour réaliser des comportements complexes. Par exemple, le module peut utiliser des compteurs pour compter le temps avant de changer une sortie (introduction d'un délai), peut utiliser plusieurs données de mesure consécutives qui sont mémorisées pour réaliser des filtres, etc.

Puisque chaque module exécute le même programme, chaque module utilise les mêmes types de variable locale, mais ces variables locales sont bien entendu propres à chaque module. L'ensemble ou une partie de ces variables locales peut ainsi se présenter comme une matrice distribuée (au même titre qu'un algorithme distribué) où chaque module a accès seulement à sa propre case de la matrice.

L'avantage de la programmation synchrone est sa simplicité et sa facilité de mise en place, ainsi que sa fiabilité. D'autre part, la réactivité d'une telle programmation est extrême et précisément connue, avec une latence équivalente à la période d'échantillonnage.

Comme introduit précédemment, il peut être pertinent de considérer les orientations des modules 1 dans l'installation, impliquant l'emploi d'algorithmes géométriques distribués.

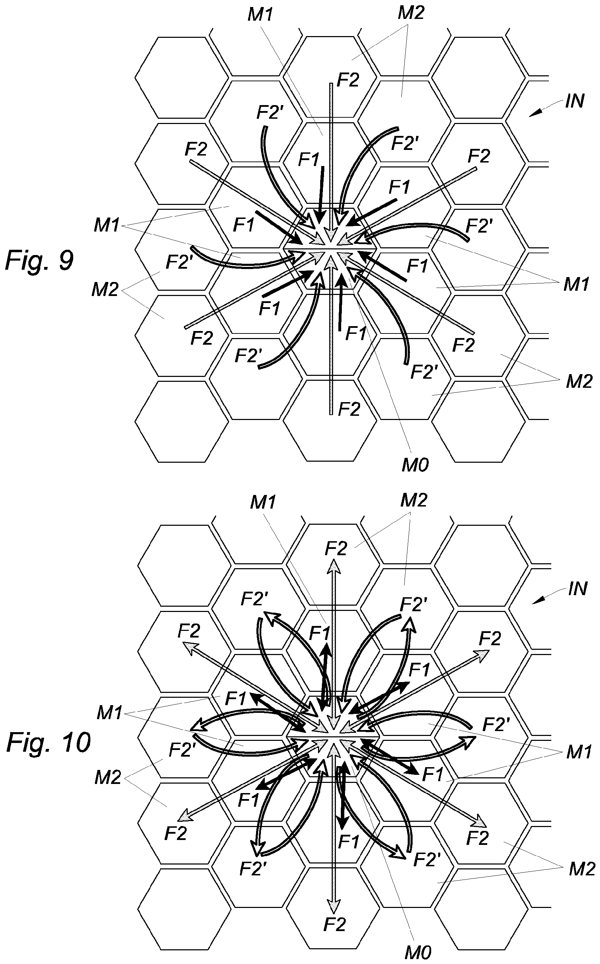

Pour la suite, nous considérerons, en référence à la figure 9, un module 1 pourvu d'une embase hexagonale et de six connecteurs disposés sur les six arêtes respectives de l'embase, autrement dit un module 1 du même type que celui des figures 1, 2a et 2b. Sur la figure 9, le contrôleur, le ou les émetteurs de signaux et le ou les capteurs ne sont pas illustrés pour des questions de clarté.

Ces modules 1 dits hexagonaux sont symétriques et peuvent être tournés à l'intérieur de l'installation, de sorte qu'il n'est pas possible de se fier à une orientation homogène de tous les modules 1. Ainsi, les connecteurs font l'objet d'une numérotation C0, C1, C2, C2, C3, C4, C5 à l'intérieur de l'installation, qui traduit l'orientation des modules.

Le ou les algorithmes distribués tiennent compte de l'orientation des modules 1 en proposant une option de rotation aléatoire de tous les modules 1 sauf le module maître, le module maître servant de référence pour l'orientation des modules esclaves.

Dans le cas d'une installation planaire, il est possible de déterminer pour chaque module, par un algorithme de vague, sa rotation en relation avec le module maître, et ainsi d'attribuer une numérotation des connecteurs de chaque module.

Dans certaines applications (tels que la génération de dessins, textes ou autres formes géométriques dans une installation composée de modules lumineux), il faut en outre un système de coordonnées géométriques des modules à l'intérieur de l'installation.

Dans le cas d'une installation planaire, il est possible de déterminer, par un algorithme de vague, les coordonnées géométriques des modules en prenant un module de référence, comme par exemple le module maître. Pour cette détermination des coordonnées géométriques, il est nécessaire de calculer le déplacement de modules par rapport aux directions des canaux.

Dans le cas d'une installation volumique (notamment en forme de surface courbe), il est délicat d'établir un système global de coordonnées, mais il est toujours possible de définir localement un système de coordonnées.

Il est également possible d'utiliser les coordonnées géométriques pour délimiter un sous-réseau de modules accessibles à partir d'une position géométrique d'un agent. Ainsi, un programme (ou « broadcast ») local peut être délimité à la fois par une distance géométrique et topologique, et l'agent peut alors contrôler le voisinage du module avec des applications variées, comme par exemple des applications de dessins locaux, etc.

Connaissant la topologie des émetteurs de signaux à l'intérieur des modules, les orientations des modules et le système de coordonnées géométriques, il est alors possible d'attribuer à chaque module et à chaque émetteur de signaux des coordonnées géométriques. Ainsi, avec des modules lumineux, il est possible de réaliser une installation modulaire avec un gestion type « pixel », où chaque module calcule pour chaque émetteur de signaux une valeur d'éclairage (allumé/éteint, intensité lumineuse, coloration, etc.) en fonction des coordonnées.

La structure même de l'installation donne accès pour chaque module, avec un cycle de retard, aux valeurs déposés par les modules voisins sur les sorties de communication correspondantes. Autrement dit, lors de la phase d'exécution, à chaque cycle, le ou chaque paquet de donnée entrant dans un cycle courant correspond à un paquet de donnée sortant transmis lors du cycle précédent par un module voisin sur la sortie de communication connectée à ladite entrée de communication du module, et le ou chaque paquet de donnée sortant transmis dans un cycle courant est réceptionné par le module voisin concerné dans le cycle suivant.

Cependant, il peut être souhaitable que chaque module 1 réceptionne des données de sortie en provenance de modules non voisins (autrement appelés modules voisins de rang n, avec n ≥ 2) et donc plus éloignés que les modules voisins (autrement appelés modules voisins de rang 1) ; étant indiqué que la transmission de données entre modules non voisins nécessite forcément plusieurs cycles. L'intérêt de recueillir de telles données permet à chaque module d'avoir une connaissance plus large de son environnement, au-delà des modules voisins, et ces données seront intégrées comme variables d'entrée supplémentaires dans l'exécution de l'algorithme de pilotage.

La figure 9 illustre une installation IN du même type que celle de la figure 8 ; la numérotation des connecteurs n'étant pas indiquée sur la figure 9, nous nous reporterons utilement à la figure 8 pour cette numérotation.

La figure 9 montre la communication de données entre, d'une part, un module dit central M0 et, d'autre part, des modules voisins (ou modules voisins de rang 1) M1 et des modules non voisins M2 qui sont en fait des modules voisins de rang 2 ; en comptant six modules M1 et douze modules M2 (en l'absence de trous dans le pavage de l'installation IN).

Les six flèches F1 représentent les communications de variables d'entrée en provenance des six modules M1 respectifs et à destination du module central M0 ; ces communications étant directes avec un cycle de retard entre la transmission et la réception.

Les douze flèches F2, F2' représentent les communications de variables d'entrée en provenance des douze modules M2 respectifs et à destination du module central M0 ; ces communications étant indirectes car transitant par les modules M1, avec au moins deux cycles de retard entre la transmission et la réception. Autrement dit, les flèches F2, F2' correspondent à des routages d'informations en passant par les modules M1 traversés.

Pour réaliser ces communications F1, F2, F2' pour la collection de valeurs de variables d'entrée pour le module central M0 en provenance de chacun des modules M1, M2 à un moment donné, il est envisageable d'employer trois cases dédiées dans un tableau de sortie out[i][j] et dans un tableau d'entrée in[i][j] pour chaque module, où l'index i représente une direction du module voisin de la communication et j représente un bloc de la trame. On peut alors envisager d'utiliser out[i][0] et in[i][0] pour les liaisons directes F1 ainsi que in[i][1] et out[i][1] pour les liaisons indirectes F2 et in[i][2] et out[i][2] pour les liaisons indirectes F2'.

Le routage des données dans les communications F2, F2' se produit dans les modules M1 intermédiaires par des affectations du type out[3][1]=in[0][0] pour la communication F2 qui vient d'en haut, et out[3][2]=in[1][0] pour la communication F2' qui vient d'en haut à droite.

Pour synchroniser les informations des différentes sources, le module central M0 peut prévoir un tampon : les valeurs reçues par les communications F1 seraient alors gardées par le module central M0 dans un tampon pendant un cycle, en attendant les valeurs reçues par les communications F2, F2'.

Si chaque module applique le même principe de routage, alors il est possible que la communication avec les modules voisins et éloignés soit bidirectionnelle, ainsi qu'illustrée sur la figure 10 où les communications F1, F2 et F21' sont toutes bidirectionnelles, avec la mise en oeuvre de routages de données dans les modules M1 intermédiaires.

Il est bien entendu envisageable de prendre en compte des communications F3, ... FN entre le module M0 et des modules voisins de rang 3, ..., N ; ces communications F3, ... FN transitant par routage dans les modules M1, M2, ..., M(N-1) intermédiaires.

La suite de la description concerne le fonctionnement de la communication entre les modules pendant la seconde phase d'exécution de l'algorithme de pilotage.

Idéalement, la seconde phase d'exécution repose sur un fonctionnement synchrone périodique des modules de l'installation et des algorithmes distribués. À chaque cycle, une quantité fixe d'information est échangée entre modules voisins, puis chaque module exécute un cycle de son programme ou algorithme de pilotage. Pour s'approcher de cet idéal synchrone, la phase d'exécution repose sur un fonctionnement pseudo-synchrone, avec la mise en oeuvre de l'un ou l'autre des deux modes de communication suivants :
- un premier mode communication basé sur une seule source de rythme (le module maître) et sans contrôle de gigue, ce premier mode étant à favoriser pour le démarrage de l'installation ainsi que pour l'identification de modules défectueux ; et
- un second mode basé sur un nombre variable de sources de rythme avec contrôle de gigue, ce second mode étant à favoriser pour un fonctionnement optimisé après démarrage de l'installation.

Dans les deux modes, pendant la phase d'exécution, le contrôleur du module maître transmet un signal de synchronisation qui est propagé aux autres modules, de sorte que les modules échangent entre eux des trames (ou paquets) de données répartis dans des cycles périodiques successifs (de période P), où chaque trame est divisée en une pluralité d'intervalles de temps dont un intervalle de temps réservé pour un signal de synchronisation et des intervalles de temps suivants réservés pour les variables locales décrites ci-dessus, et utiles à l'exécution de l'algorithme de pilotage.

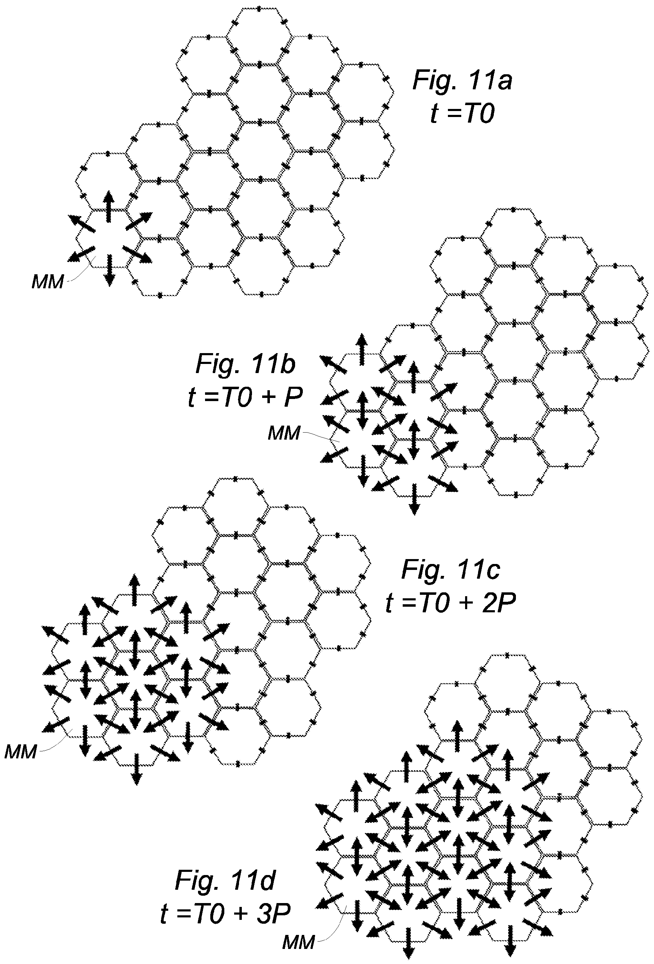

Le premier mode communication repose sur un fonctionnement localement synchrone et sans contrôle de gigue, dans lequel la source unique de rythme est donnée par un signal de synchronisation au début de chaque cycle envoyé par le contrôleur du module maître. La description de ce premier mode communication est faire en référence aux figures 11a à 11d et 12a à 12c.

En référence à la figure 11a, un seul module (en l'occurrence le module maître MM) crée le rythme en distribuant, sur les sorties de communication de ses connecteurs, un signal de synchronisation au début du cycle avec une période P. Cette distribution est illustrée sur la figure 12a par les flèches qui parte du module MM en direction de ses modules voisins.

En référence aux figures 11b à 11d, ce signal de synchronisation est propagé par les connecteurs des modules. Le module maître donne ainsi le rythme ou la période au moyen de ce signal de synchronisation.

En référence à la figure 12a, le signal de synchronisation est propagé par les connecteurs des modules, et cette propagation marque le début du cycle pour chaque module. Un module M1 qui reçoit le signal de synchronisation sur une de ses entrées (signal S1) le propage aux modules voisins M2 sur ses sorties de communication qui le reçoive (signal S2) dans un délai compris entre ε et ε + γ, avec :
- ε le temps de propagation minimal entre le contrôleur d'un module M1 et le contrôleur du module voisin M2 suivant ; et
- γ la gigue du cycle ;

Le résultat de ce décalage temporel est que chaque couple de modules voisins liés directement par leurs connecteurs respectifs, sont liés par un décalage temporel du cycle borné par ε + γ.

En référence à la figure 12b, la gigue du cycle pour chaque module à un rang n du module maître MM, peut varier avec ny. Un module de rang 2 par rapport au module maître MM est en décalage temporel compris entre 2ε et (2ε + 2γ), et un module de rang n par rapport au module maître MM est en décalage temporel compris entre nε et (nε + nγ). Il est donc nécessaire de s'assurer que le temps prévu pour la communication plus la gigue cumulative ny ne dépasse pas la période P des cycles de communication.

En référence à la figure 12c, pour répondre à cette problématique, il est prévu que, durant période P (autrement dit pendant chaque cycle C), le contrôleur de chaque module esclave non maître situé à un rang n par rapport au module maître MM, distribue un paquet de données PD se subdivisant en plusieurs intervalles de temps alloués de la manière suivante :
- un premier intervalle de temps IN1 alloué au signal de synchronisation Sync ;
- un second intervalle de temps IN2 dit d'attente vide de données, ledit second intervalle de temps présentant une durée T2 où T2 ≥ ε + γ ;
- un troisième intervalle IN3 de temps alloué aux variables de sortie (qui seront pour rappel les variables d'entrée du module voisin qui réceptionne ce paquet) ; et
- un quatrième intervalle de temps IN4 dit de pause, ledit quatrième intervalle de temps présentant une durée T4, où T4 ≥ ε + nγ, avec n le rang du module par rapport au module maître MM dans la chaîne de communication.

Ainsi, les modules voisins M1, M2 communiquent entre eux en se transmettant, à chaque cycle C, des paquets de données PD subdivisés de la manière décrite ci-dessus, avec bien entendu le décalage temporel présent dans cette communication.

Le second intervalle de temps IN2 dit d'attente garantit qu'un module voisin M2 en retard sera prêt pour la réception de données lors de leur envoi.

Le quatrième intervalle de temps IN4 dit de pause, situé à la fin du cycle C, permet de conclure la réception dans le module voisin en avance et d'attendre le prochain signal de synchronisation tout en compensant la gigue cumulative nγ. On note ainsi que la gigue cumulative nγ peut limiter la partie utile pour la communication de chaque cycle C, de sorte que ce premier mode communication nécessite une estimation de la gigue maximale dans l'installation.

Le second mode communication repose sur un fonctionnement localement synchrone avec contrôle de gigue, qui est adapté pour limiter la gigue locale, et ainsi augmenter la partie utile des paquets de données à chaque cycle de communication, en bornant la gigue dans chaque module.

Avec ce second mode communication, le contrôleur de chaque module esclave réalise les étapes suivantes :
- s'il s'est écoulé, depuis la réception du signal de synchronisation du paquet de données du cycle précédent provenant d'un module voisin dit précédent, un intervalle de temps dit de retard Tretard, alors ledit contrôleur transmet un paquet de données avec un signal de synchronisation aux autres modules voisins dits suivants sans attendre le signal de synchronisation du paquet de données du cycle suivant qui proviendra dudit module voisin précédent, où :
   Tretard = P + ε + γ, avec
   P la durée du cycle du module maître ;
   ε le temps de propagation minimal entre le contrôleur d'un module et le contrôleur du module voisin suivant ; et
   γ la gigue du cycle ;
- si, à la réception du signal de synchronisation d'un paquet de données du cycle courant provenant d'un module voisin précédent, il existe, depuis la réception du signal de synchronisation du cycle précédent provenant dudit module voisin précédent, un intervalle de temps dit d'avance Tavance, alors le contrôleur attend un intervalle de temps Tdécal avant de transmettre sur ses sorties le paquet de données aux modules voisins suivants, où :
   Tavance ≤ P + δ, avec
   δ le temps de décalage entre le cycle du module et le cycle du module voisin précédent, où δ ≤ ε + γ.

Autrement dit, si le signal de synchronisation du cycle suivant arrive en retard, c'est-à-dire après l'écoulement de l'intervalle de retard Tretard suite à la réception du précédent signal de synchronisation, alors le module va commencer le cycle sans attendre le signal de synchronisation. Par conséquent, ce module va créer le signal de synchronisation pour ses modules voisins (on parle donc d'une communication avec un nombre variable de sources de rythme).

A contrario, si le signal de synchronisation du cycle suivant arrive trop tôt, le module attendra l'intervalle de temps Tdécal avant de relayer, avec Tdécal = P + ε - γ.

Ainsi, pour chaque module, la gigue de durée de cycles et de génération du signal de synchronisation est limitée à γ, et le décalage dans la communication avec les voisins est limité à (ε + γ). Ainsi, on constate que le système se stabilise vers un début de cycle qui correspond à la distance (ou rang n) vis-à-vis de la source de temps (le module maître) multipliée par (ε + γ/2).

La suite de la description concerne la latence dans l'installation, durant la phase d'exécution, inhérente la programmation synchrone, et sur la limitation de cette latence par la mise en oeuvre d'un protocole de routage des données.

Comme décrit ci-dessus, la programmation synchrone implique, pour chaque contrôleur de module, l'intégration étroite de l'exécution des deux phases suivantes :
- phase de communication qui permet de propager et de communiquer des valeurs des variables d'un module à destination de ses modules voisins ;
- phase de calcul pour l'exécution d'un programme de pilotage du module, comprenant le traitement des différentes variables (variables d'entrée, données de mesure, variables d'état) et la modification des variables propres au module.

Dans ce principe, les variables communiquées dans le cycle courant par les modules voisins représentent des valeurs écrites par ces mêmes modules lors du cycle précédent, de sorte que la latence de lecture des variables entre modules voisins est d'un cycle (ou d'une période).

Cette latence a pour conséquence globale une sorte de vitesse de flux d'informations dans l'installation qui serait d'un saut par cycle. Toutefois, cette latence peut être évitée si l'on utilise le protocole suivant de routage.

Avec ce protocole de routage des données, durant chaque cycle, les paquets de données échangés entre deux modules voisins sont découpées et envoyées en plusieurs groupes répartis sur des intervalles de temps supérieurs à un temps de décalage de la propagation entre deux modules voisins de rang n et n+1 respectivement, de sorte que chaque octet d'un groupe d'ordre NO est reçu sur un connecteur avant l'envoi de l'octet correspondant d'un groupe d'ordre supérieur NO+1 sur un autre connecteur

En effet, durant chaque cycle, selon la vitesse de communication et la durée du cycle, une certaine quantité d'information peut passer d'un module à son module voisin. Cette communication entre deux modules est synchrone sur tous les connecteurs, sauf pour le décalage et la gigue.

En découpant l'ensemble des données envoyées en plusieurs groupes (de plusieurs octets) d'une taille suffisante pour assurer que l'envoi d'un groupe dépasse le décalage entre modules voisins, il est assuré que chaque octet d'un groupe d'un numéro d'ordre NO inférieur est reçu sur un connecteur avant l'envoi de l'octet correspondant d'un groupe d'ordre supérieur NO+1 sur un autre connecteur.

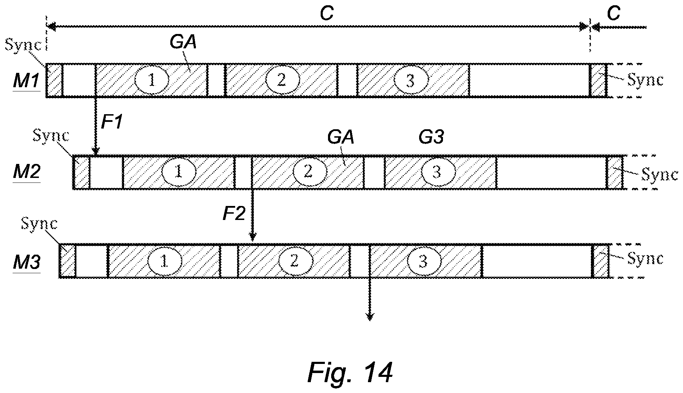

La figure 14 illustre schématiquement ce protocole de routage, qui montre :
- l'envoi (flèche F1) d'un groupe de données GA de numéro d'ordre 1 du module M1 au module M2, puis
- le même groupe GA est envoyé (flèche F2) du module M2 au module M3 en tant que groupe de numéro d'ordre 2, et ainsi de suite.

Il bien entendu possible de router dans le sens inverse, d'un groupe d'ordre supérieur NO vers un groupe d'ordre inférieur NO-1, mais ceci dans deux cycles successifs et non dans le même cycle. Il est également avantageux de prévoir une table de routage pour automatiser les flux routés.

Ce protocole de routage permet de réduire d'une manière significative la latence dans le réseau, jusqu'à un facteur M pour le cas de Z groupes d'octets où, dans un cycle, les données traversent jusqu'à Z modules.

L'intégration de ce protocole de routage avec la programmation synchrone décrite ci-dessus consistera par exemple en un classement de deux classes de groupes, ceux pour lesquels la communication se fait entre deux exécutions du programme de pilotage (et donc avec une latence inhérente d'un cycle) et ceux qui sont communiqués pendant l'exécution du programme de pilotage (dans un double tampon et de ce fait avec une latence de deux cycles).

Il est cependant à noter que ces latences de un ou deux cycles ne s'accumulent pas pour le nombre de sauts, de module en module. A titre d'exemple, si un groupe d'octets réalise cinq sauts dans un cycle, alors sa latence sur une distance de quatre sauts serait de un ou deux cycles (selon les deux types de groupes précités), et sa latence sur une distance de sept sauts serait de deux ou trois cycles. Cette latence peut être calculée précisément pour chaque module et chaque cas.

Bien que complexifiant la programmation, ce protocole de routage permet, avantageusement, qu'à chaque cycle, un module peut utiliser des variables non plus seulement des voisins directs, mais également de voisins situés à des rangs supérieurs ou égales à deux.

## Revendications

1. Module (1) programmable pour une installation (IN) modulaire d'émetteurs de signaux lumineux (3), ledit module (1) comprenant :
- une embase (2) de support délimitée par des arêtes (20) ;
- au moins un émetteur de signaux lumineux (3) fixé sur ladite embase (2) ;
- au moins un contrôleur (4) fixé sur ladite embase (2) et relié audit au moins un émetteur de signaux lumineux (3) pour piloter l'émission des signaux lumineux ;
- au moins deux connecteurs (5) fixés sur les arêtes (20) de ladite embase (2) et reliés audit contrôleur (4), chaque connecteur (5) présentant :
- une interface d'alimentation électrique dudit au moins un émetteur de signaux lumineux (3) et dudit au moins un contrôleur (4) ; et
- une interface de communication bidirectionnelle raccordée audit au moins un contrôleur (4) et présentant une entrée de communication et une sortie de communication ;
où l'un au moins desdits connecteurs (5) peut être connecté avec un connecteur (5) d'un module (1) voisin dans l'installation (IN) modulaire pour permettre une communication bidirectionnelle entre le contrôleur (4) dudit module (1) et le contrôleur (4) dudit module (1) voisin et une distribution de l'alimentation électrique entre les modules (1) ;
ledit module (1) étant **caractérisé en ce que** le contrôleur (4) fonctionne sur la base d'algorithmes distribués et synchrones afin de pouvoir réaliser des tâches de pilotage et de surveillance du ou des émetteurs de signaux lumineux (3), de communication bidirectionnelle avec les contrôleurs (4) du ou des modules (1) voisins, d'écoute sur les interfaces de communication des connecteurs (5), et de réception et de transmission de données sur les interfaces de communication des connecteurs (5).

2. Module (1) selon la revendication 1, dans lequel au moins un émetteur de signaux lumineux (3) est du type diode électroluminescente.

3. Module (1) selon les revendications 1 ou 2, comprenant en outre au moins un capteur de mesure d'un paramètre local fixé sur l'embase (2), notamment du type capteur de proximité, ledit au moins un capteur générant des données de mesure locale et le contrôleur (4) étant relié audit au moins un capteur pour recevoir lesdites données de mesure locale.

4. Module (1) selon l'une quelconque des revendications précédentes, dans lequel le module (1) comporte un connecteur (5) sur chaque arête (20).

5. Installation (IN) modulaire du type comprenant plusieurs modules (1) conformes à l'une quelconque des revendications précédentes, dans laquelle chaque module (1) présente au moins un connecteur (5) connecté à un connecteur (5) d'un module (1) voisin.

6. Installation (IN) modulaire selon la revendication 5, dans laquelle l'embase (2) de chaque module (1) présente au moins une arête (20) sur laquelle est fixé un connecteur (5), où ladite arête (20) est jointive d'une arête (20) de l'embase (2) d'un module (1) voisin sur laquelle est également fixé un connecteur (5), et les deux connecteurs (5) fixés sur lesdites arêtes (20) jointives sont interconnectés.

7. Installation (IN) modulaire selon les revendications 5 ou 6, dans laquelle les embases (2) des modules (1) sont réparties selon un pavage planaire ou volumique, l'embase (2) de chaque module (1) étant disposée de manière jointive avec l'embase (2) d'au moins un module (1) voisin, et chaque module (1) étant connecté à son ou ses modules (1) voisins par leurs connecteurs (5) respectifs.

8. Installation (IN) modulaire selon l'une quelconque des revendications 5 à 7, comprenant en outre une source unique d'un programme de pilotage des contrôleurs (4) des modules (1), ladite source étant prévue pour être connectée à un contrôleur (4) d'un module (1) dit maître.

9. Procédé de pilotage synchrone d'une installation (IN) modulaire d'émetteurs de signaux lumineux (3), ledit procédé comprenant les étapes suivantes :
• fourniture de plusieurs modules (1) programmables, dans lequel chaque module (1) comprend:
- une embase (2) de support délimitée par des arêtes (20) ;
- au moins un émetteur de signaux lumineux (3) fixé sur ladite embase (2) ;
- au moins un contrôleur (4) fixé sur ladite embase (2) et relié audit au moins un émetteur de signaux lumineux (3) pour piloter l'émission des signaux lumineux ;
- au moins deux connecteurs (5) fixés sur les arêtes (20) de ladite embase (2) et reliés audit contrôleur (4), chaque connecteur (5) présentant :
- une interface d'alimentation électrique dudit au moins un émetteur de signaux lumineux (3) et dudit au moins un contrôleur (4) ; et
- une interface de communication bidirectionnelle raccordée audit au moins un contrôleur (4) et présentant une entrée de communication et une sortie de communication ;
• connexion des modules (1) entre eux de sorte que chaque module (1) présente au moins un connecteur (5) connecté à un connecteur (5) d'un module (1) voisin dans l'installation (1), où deux modules (1) voisins présentent des arêtes (20) adjacentes et la connexion entre les deux modules (1) voisins se fait en connectant les connecteurs (5) placés sur ces arêtes (20) ;
• établissement d'une communication bidirectionnelle et d'une distribution de l'alimentation électrique entre le contrôleur (4) de chaque module (1) et le contrôleur (4) du ou des modules (1) voisins dans l'installation (1) ;
• pour chaque module (1), programmation du contrôleur (4) pour fonctionner sur la base d'algorithmes distribués et synchrones afin de réaliser des tâches de pilotage et de surveillance du ou des émetteurs de signaux lumineux (3), de communication bidirectionnelle avec les contrôleurs (4) du ou des modules (1) voisins, d'écoute sur les interfaces de communication des connecteurs (5), et de réception et de transmission de données sur les interfaces de communication des connecteurs (5) ;
• pour chaque module (1), exécution du même programme d'une manière cyclique périodique et synchrone, dans lequel, à chaque cycle, chaque module (1) établit une communication bidirectionnelle avec le ou les modules (1) voisins et exécute un ou plusieurs algorithmes distribués et synchrones dudit programme.

10. Procédé selon la revendication 9, dans lequel un module dit maître constitue une source unique du rythme périodique pour l'exécution du même programme par les modules (1), où ledit module maître génère un signal de synchronisation qui est propagé de proche en proche entre les modules (1) en partant du module maître via leurs connecteurs respectifs.

11. Procédé selon les revendications 9 ou 10, dans lequel l'exécution du même programme par les modules (1) est précédée d'une phase d'entrée d'un algorithme de pilotage au contrôleur (4) d'au moins un module (1) dit maître, sous la forme de trames de données répartis dans des cycles périodiques successifs, les autres modules (1) étant dits esclaves, et dans lequel l'exécution du même programme par les modules (1) comporte les phases suivantes :
- une première phase d'exécution d'un algorithme de distribution dans lequel des trames de données de l'algorithme de pilotage sont distribuées de manière synchrone et périodique, de proche en proche entre les modules (1) en partant d'un au moins un module (1) dit maître ;
- une fois que l'algorithme de pilotage distribué est complètement chargé dans tous les contrôleurs (4), une seconde phase d'exécution de l'algorithme de pilotage par chaque contrôleur (4) de manière synchrone et périodique.

12. Procédé selon la revendication 11, dans lequel la première phase de distribution est précédée d'une phase de détermination d'une distance maximale correspondant à la plus grande distance entre le au moins un module (1) maître et le ou les modules (1) esclaves les plus éloignés dans l'installation (IN) en cheminant de module (1) voisin en module (1) voisin selon le ou les chemins les plus courts, pour établir le temps nécessaire à la phase de distribution pour que l'algorithme de pilotage distribué soit complètement chargé dans tous les contrôleurs (4).

13. Procédé selon les revendications 11 ou 12, dans lequel la phase d'entrée de l'algorithme de pilotage et la première phase d'exécution de l'algorithme de distribution sont réalisées :
- soit de manière séquentielle, où ladite première phase débute une fois que l'algorithme de pilotage est complètement chargé dans le contrôleur (4) du au moins un module (1) maître ;
- soit de manière parallèle, où chaque contrôleur (4) d'un module (1) reçoit dans un cycle courant une trame de données de l'algorithme de pilotage et la propage au(x) contrôleur(s) (4) du ou des modules (1) voisins dans le cycle suivant.

14. Procédé selon l'une quelconque des revendications 11 à 13, dans lequel, lors de la première phase d'exécution de l'algorithme de distribution, à chaque cycle, le contrôleur (4) de chaque module (1) réalise les opérations suivantes :
- réception d'un signal de synchronisation sur au moins une entrée de communication, et transmission du signal de synchronisation sur les sorties de communication ;
- écoute sur toutes les entrées de communication du module (1) ;
- réception d'une trame de données de l'algorithme de pilotage sur au moins une entrée de communication du module (1), ladite trame de données correspondant à une trame de données transmise lors du cycle précédent par un module (1) voisin sur la sortie de communication connectée à ladite entrée de communication du module (1) ;
- stockage de ladite trame de données dans ledit contrôleur (4) ;
- transmission de ladite trame de données sur les sorties de communication à destination des modules (1) voisins.

15. Procédé selon l'une quelconque des revendications 11 à 14, dans lequel, lors de la seconde phase d'exécution de l'algorithme de pilotage, à chaque cycle, le contrôleur (4) de chaque module (1) réalise les opérations suivantes :
- réception d'un signal de synchronisation sur au moins une entrée de communication, et transmission du signal de synchronisation sur les sorties de communication ;
- écoute sur toutes les entrées de communication du module (1) ;
- lecture des données de mesure issues du au moins capteur ;
- lecture de variables dites d'état représentatives de l'état du module (1), notamment de l'état du au moins un émetteur de signaux lumineux (3) ;
- lecture d'un paquet de données dit entrant sur au moins une entrée de communication du module (1), ledit paquet de données intégrant au moins une variable d'entrée pour l'exécution de l'algorithme de pilotage ;
- exécution de l'algorithme de pilotage avec en entrée la ou les variables d'entrée du ou des paquets de données reçus dans le cycle courant, les données de mesure et les variables d'état, et en sortie des instructions de pilotage du ou des émetteurs de signaux lumineux (3) du module (1), une mise à jour des variables d'état, et le calcul de variables de sortie associées à chaque sortie de communication ;
- transmission sur chaque sortie de communication d'un paquet de donnée dit sortant intégrant les variables de sortie associées à chaque sortie de communication.

16. Procédé selon la revendication 15, dans lequel, lors de la seconde phase d'exécution de l'algorithme de pilotage, à chaque cycle, le ou chaque paquet de donnée entrant dans un cycle courant correspond à un paquet de donnée sortant transmis lors du cycle précédent par un module (1) voisin sur la sortie de communication connectée à ladite entrée de communication du module (1), et le ou chaque paquet de donnée sortant transmis dans un cycle courant est réceptionné par le module (1) voisin concerné dans le cycle suivant.

17. Procédé selon les revendications 15 ou 16, dans lequel la seconde phase d'exécution de l'algorithme de pilotage comprend, de préférence au début de la seconde phase, une phase de communication avec une source unique de rythme sans contrôle de gigue, la source unique de rythme étant donnée par le signal de synchronisation au début de chaque cycle envoyé par le contrôleur (4) du au moins un module (1) maître.

18. Procédé selon les revendications 15 ou 16, dans lequel la seconde phase d'exécution de l'algorithme de pilotage comprend, de préférence après le démarrage de l'installation (IN), une phase de communication avec un nombre variable de source de rythme et avec contrôle de gigue, dans lequel un contrôleur (4) d'au moins un module (1) esclave génère son propre signal de synchronisation qu'il transmet aux modules (1) voisins sur ses sorties de communication.

19. Procédé selon l'une quelconque des revendications 11 à 18, dans lequel la seconde phase d'exécution de l'algorithme de pilotage met en oeuvre un protocole de routage des données, dans lequel durant chaque cycle les paquets de données échangés entre deux modules (1) voisins sont découpées et envoyées en plusieurs groupes répartis sur des intervalles de temps supérieurs à un temps de décalage de la propagation entre deux modules (1) voisins de rang n et n+1 respectivement, de sorte que chaque octet d'un groupe d'ordre NO est reçu sur un connecteur (5) avant l'envoi de l'octet correspondant d'un groupe d'ordre supérieur NO+1 sur un autre connecteur.

## Patentansprüche

1. Programmierbares Modul (1) für eine modulare Installation (IN) von Lichtsignalgebern (3), wobei das Modul (1) umfasst:
- eine Trägerbasis (2), die durch Kanten (20) eingegrenzt wird;
- mindestens einen Lichtsignalgeber (3), der an der Basis (2) fixiert ist;
- mindestens einen Controller (4), der an der Basis (2) fixiert, und an den mindestens einen Lichtsignalgeber (3) angeschlossen ist, um die Übertragung der Lichtsignale anzusteuern;
- mindestens zwei Stecker (5), die an den Kanten (20) der Basis (2) fixiert, und an den Controller (4) angeschlossen sind, wobei jeder Stecker (5) aufweist:
- eine Stromversorgungsschnittstelle des mindestens einen Lichtsignalgebers (3) und des mindesten einen Controllers (4); und
- eine bidirektionale Kommunikationsschnittstelle, die an den mindestens einen Controller (4) angeklemmt ist, und einen Kommunikationseingang und einen Kommunikationsausgang aufweisend;
wo mindestens der eine der Stecker (5) mit einem Stecker (5) eines benachbarten Moduls (1) in der modularen Installation (IN) verbunden werden kann, um eine bidirektionale Kommunikation zwischen dem Controller (4) des Moduls (1) und dem Controller (4) des benachbarten Moduls (1) und eine Stromversorgungsverteilung zwischen den Modulen (1) zu ermöglichen;
wobei das Modul (1) **dadurch gekennzeichnet ist, dass** der Controller (4) auf der Grundlage von verteilten und synchronen Algorithmen funktioniert, um Aufgaben zum Ansteuern und Überwachen des oder der Lichtsignalgeber (3), zur bidirektionalen Kommunikation mit den Controllern (4) des oder der benachbarten Module (1), zum Abhören auf den Kommunikationsschnittstellen der Stecker (5), und zum Empfangen und Übermitteln von Daten auf den Kommunikationsschnittstellen der Stecker (5) ausführen zu können.

2. Modul (1) nach Anspruch 1, wobei mindestens ein Lichtsignalgeber (3) in der Art einer Elektrolumineszenzdiode ist.

3. Modul (1) nach den Ansprüchen 1 oder 2, weiter umfassend mindestens einen Messsensor eines lokalen Parameters, der an der Basis (2) fixiert ist, insbesondere in der Art eines Näherungssensors, wobei der mindestens eine Sensor Daten einer lokalen Messung erzeugt, und der Controller (4) an den mindestens einen Sensor angeschlossen ist, um die Daten einer lokalen Messung zu empfangen.

4. Modul (1) nach einem der vorstehenden Ansprüche, wobei das Modul (1) einen Stecker (5) an jeder Kante (20) beinhaltet.

5. Modulare Installation (IN), in der Art mehrere Module (1) nach einem der vorstehenden Ansprüche umfassend, wobei jedes Modul (1) mindestens einen Stecker (5) aufweist, der mit einem Stecker (5) eines benachbarten Moduls (1) verbunden ist.

6. Modulare Installation (IN) nach Anspruch 5, wobei die Basis (2) jedes Moduls (1) mindestens eine Kante (20) aufweist, an dem ein Stecker (5) fixiert ist, wo die Kante (20) mit einer Kante (20) der Basis (2) eines benachbarten Moduls (1) aneinandergesetzt ist, an der ebenfalls ein Stecker (5) fixiert ist, und die beiden Stecker (5), die an den aneinandergesetzten Kanten (20) fixiert sind, miteinander verbunden sind.

7. Modulare Installation (IN) nach den Ansprüchen 5 oder 6, wobei die Basen (2) der Module (1) gemäß einer ebenen oder räumlichen Pflasterung verteilt sind, wobei die Basis (2) eines jeden Moduls (1) in aneinandergesetzter Weise mit der Basis (2) mindestens eines benachbarten Moduls (1) angeordnet ist, und jedes Modul (1) mit seinem oder seinen benachbarten Modulen (1) durch deren jeweilige Stecker (5) verbunden ist.

8. Modulare Installation (IN) nach einem der Ansprüche 5 bis 7, weiter umfassend eine einzige Quelle eines Ansteuerungsprogramms der Controller (4) der Module (1), wobei die Quelle vorgesehen ist, um mit einem Controller (4) eines Master genannten Moduls (1) verbunden zu werden.

9. Verfahren zum synchronen Ansteuern einer modularen Installation (IN) von Lichtsignalgebern (3), wobei das Verfahren die folgenden Schritte umfasst:
• Bereitstellen mehrerer programmierbarer Module (1), wobei jedes Modul (1) umfasst:
- eine Trägerbasis (2), die durch Kanten (20) eingegrenzt wird;
- mindestens einen Lichtsignalgeber (3), der an der Basis (2) fixiert ist;
- mindestens einen Controller (4), der an der Basis (2) fixiert, und an den mindestens einen Lichtsignalgeber (3) angeschlossen ist, um die Übertragung der Lichtsignale anzusteuern;
- mindestens zwei Stecker (5), die an den Kanten (20) der Basis (2) fixiert, und an den Controller (4) angeschlossen sind, wobei jeder Stecker (5) aufweist:
- eine Stromversorgungsschnittstelle des mindestens einen Lichtsignalgebers (3) und des mindestens einen Controllers (4); und
- eine bidirektionale Kommunikationsschnittstelle, die an den mindestens einen Controller (4) angeklemmt ist, und einen Kommunikationseingang und einen Kommunikationsausgang aufweist;
• Verbinden der Module (1) miteinander, sodass jedes Modul (1) mindestens einen Stecker (5) aufweist, der mit einem Stecker (5) eines benachbarten Moduls (1) in der Installation (1) verbunden ist, wo zwei benachbarte Module (1) angrenzende Kanten (20) aufweisen, und das Verbinden zwischen den beiden benachbarten Modulen (1) durch Verbinden der Stecker (5) erfolgt, die auf diesen Kanten (20) platziert sind;
• Aufbauen einer bidirektionalen Kommunikation und einer Verteilung der Stromversorgung zwischen dem Controller (4) jedes Moduls (1) und dem Controller (4) des oder der benachbarten Module (1) in der Installation (1);
• für jedes Modul (1) Programmieren des Controllers (4) zum Funktionieren auf der Grundlage von verteilten und synchronen Algorithmen, um Aufgaben zum Ansteuern und zum Überwachen des oder der Lichtsignalgeber (3), zur bidirektionalen Kommunikation mit den Controllern (4) des oder der benachbarten Module (1), zum Abhören auf den Kommunikationsschnittstellen der Stecker (5), und zum Empfangen und Übermitteln von Daten auf den Kommunikationsschnittstellen der Stecker (5) auszuführen;
• für jedes Modul (1) Ausführen desselben Programms auf eine periodische und synchrone zyklische Weise, wobei bei jedem Zyklus jedes Modul (1) eine bidirektionale Kommunikation mit dem oder den benachbarten Modulen (1) aufbaut und einen oder mehrere verteilte und synchrone Algorithmen des Programmes ausführt.

10. Verfahren nach Anspruch 9, wobei ein Master genanntes Modul eine einzige Quelle des periodischen Rhythmus zum Ausführen desselben Programms durch die Module (1) bildet, wo das Master-Modul ein Synchronisationssignal generiert, das von nah zu nah zwischen den Modulen (1) ausgehend von dem Master-Modul über deren jeweilige Stecker propagiert wird.

11. Verfahren nach den Ansprüchen 9 oder 10, wobei der Ausführung desselben Programms durch die Module (1) eine Eingabephase eines Ansteuerungsalgorithmus in den Controller (4) mindestens eines Master genannten Moduls (1) in der Form von in aufeinanderfolgenden periodischen Zyklen verteilten Datenrahmen vorangeht, wobei die anderen Module (1) Slaves genannt werden, und wobei die Ausführung desselben Programms durch die Module (1) die folgenden Phasen beinhaltet:
- eine erste Ausführungsphase eines Verteilalgorithmus, wobei die Datenrahmen des Ansteuerungsalgorithmus in synchroner und periodischer Weise, von nah zu nah zwischen den Modulen (1) ausgehend von einem mindestens einen Master genannten Modul (1) verteilt werden;
- sobald der verteilte Ansteuerungsalgorithmus vollständig in allen Controllern (4) geladen ist, eine zweite Ausführungsphase des Ansteuerungsalgorithmus durch jeden Controller (4) in synchroner und periodischer Weise.

12. Verfahren nach Anspruch 11, wobei der ersten Verteilungsphase eine Bestimmungsphase einer maximalen Distanz entsprechend der größten Distanz zwischen dem mindestens einen Master-Modul (1) und dem oder den entferntesten Slave-Modulen (1) in der Installation (IN) durch Wegbeschreiten von benachbartem Modul (1) zu benachbartem Modul (1) entlang des oder der kürzesten Wege, vorangeht, um die für die Verteilungsphase nötige Zeit festzulegen, damit der verteilte Ansteuerungsalgorithmus vollständig in alle Controller (4) geladen wird.

13. Verfahren nach den Ansprüchen 11 oder 12, wobei die Eingabephase des Ansteuerungsalgorithmus und die erste Ausführungsphase des Verteilungsalgorithmus durchgeführt werden:
- entweder in sequenzieller Weise, wo die erste Phase beginnt, sobald der Ansteuerungsalgorithmus vollständig in den Controller (4) des mindestens einen Master-Moduls (1) geladen ist;
- oder in paralleler Weise, wo jeder Controller (4) eines Moduls (1) in einem laufenden Zyklus einen Datenrahmen von dem Ansteuerungsalgorithmus empfängt, und ihn in dem folgenden Zyklus auf den (die) Controller (4) des oder der benachbarten Module (1) propagiert.

14. Verfahren nach einem der Ansprüche 11 bis 13, wobei der Controller (4) jedes Moduls (1) bei der ersten Ausführungsphase des Verteilungsalgorithmus in jedem Zyklus die folgenden Operationen durchführt:
- Empfangen eines Synchronisationssignals an mindestens einem Kommunikationseingang, und Übermitteln des Synchronisationssignals auf die Kommunikationsausgänge;
- Abhören auf allen Kommunikationseingängen des Moduls (1);
- Empfangen eines Datenrahmens von dem Ansteuerungsalgorithmus an mindestens einem Kommunikationseingang des Moduls (1), wobei der Datenrahmen einem bei dem vorstehenden Zyklus durch ein benachbartes Modul (1) an dem mit dem Kommunikationseingang des Moduls (1) verbundenen Kommunikationsausgang übermittelten Datenrahmen entspricht;
- Speichern des Datenrahmens in dem Controller (4);
- Übermitteln des Datenrahmens an den Kommunikationsausgängen an die benachbarten Module (1).

15. Verfahren nach einem der Ansprüche 11 bis 14, wobei der Controller (4) jedes Moduls (1) bei der zweiten Ausführungsphase des Ansteuerungsalgorithmus in jedem Zyklus die folgenden Operationen durchführt:
- Empfangen eines Synchronisationssignals an mindestens einem Kommunikationseingang, und Übermitteln des Synchronisationssignals an den Kommunikationsausgängen;
- Abhören auf allen Kommunikationseingängen des Moduls (1);
- Lesen der Messdaten aus dem mindestens einen Sensor;
- Lesen von sogenannten, für den Zustand des Moduls (1) repräsentativen Zustandsvariablen, insbesondere für den Zustand mindestens eines Lichtsignalgebers (3);
- Lesen eines an mindestens einem Kommunikationseingang des Moduls (1) eingehend genannten Datenpakets, wobei das Datenpaket mindestens eine Eingangsvariable zum Ausführen des Ansteuerungsalgorithmus integriert;
- Ausführen des Ansteuerungsalgorithmus mit am Eingang der oder den Eingangsvariablen des oder der im laufenden Zyklus empfangenen Datenpakete, den Messdaten und den Zustandsvariablen, und am Ausgang Ansteuerungsinstruktionen von dem oder den Lichtsignalgebern (3) des Moduls (1), einer Aktualisierung der Zustandsvariablen und dem Berechnen von jedem Kommunikationsausgang zugeordneten Ausgangsvariablen;
- Übermitteln an jedem Kommunikationsausgang eines ausgehend genannten Datenpakets, das die jedem Kommunikationsausgang zugeordneten Ausgangsvariablen integriert.

16. Verfahren nach Anspruch 15, wobei das oder jedes in einen laufenden Zyklus eingehende Datenpaket bei der zweiten Ausführungsphase des Ansteuerungsalgorithmus in jedem Zyklus einem bei dem vorstehenden Zyklus durch ein benachbartes Modul (1) an dem mit dem Kommunikationseingang des Moduls (1) verbundenen Kommunikationsausgang übermittelten ausgehenden Datenpaket entspricht, und das oder jedes in einem laufenden Zyklus übermittelte ausgehende Datenpaket in dem nächsten Zyklus durch das betroffene benachbarte Modul (1) empfangen wird.

17. Verfahren nach den Ansprüchen 15 oder 16, wobei die zweite Ausführungsphase des Ansteuerungsalgorithmus vorzugsweise zu Beginn der zweiten Phase eine Kommunikationsphase mit einer einzigen Rhythmusquelle ohne Schwankungskontrolle umfasst, wobei die einzige Rhythmusquelle durch das Synchronisationssignal zu Beginn jedes Zyklus gegeben ist, der durch den Controller (4) des mindestens einen Master-Moduls (1) geschickt wird.

18. Verfahren nach den Ansprüchen 15 oder 16, wobei die zweite Ausführungsphase des Ansteuerungsalgorithmus vorzugsweise nach dem Start der Installation (IN) eine Kommunikationsphase mit einer variablen Rhythmusquellenanzahl und mit Schwankungskontrolle umfasst, wobei ein Controller (4) mindestens eines Slave-Moduls (1) sein eigenes Synchronisationssignal generiert, das er an seinen Kommunikationsausgängen an die benachbarten Module (1) überträgt.

19. Verfahren nach einem der Ansprüche 11 bis 18, wobei die zweite Ausführungsphase des Ansteuerungsalgorithmus ein Datenroutingprotokoll umsetzt, wobei die in jedem Zyklus zwischen den benachbarten Modulen (1) ausgetauschten Datenpakete zerstückelt und in mehreren Gruppen geschickt werden, die auf größere Zeitintervalle als eine Verzögerungszeit der Propagation zwischen zwei benachbarten Modulen (1) jeweils eines Ranges n und n+1 aufgeteilt sind, sodass jedes Byte einer Ordnungsgruppe NO an einem Stecker (5) vor dem Schicken des einer höheren Ordnungsgruppe NO+1 an einem anderen Stecker entsprechenden Bytes empfangen wird.

## Claims

1. A programmable module (1) for a modular installation (IN) of light signal transmitters (3), said module (1) comprising:
- a support base (2) delimited by edges (20);
- at least one light signal transmitter (3) fastened on said base (2);
- at least one controller (4) fastened on said base (2) and linked to said at least one light signal transmitter (3) for driving the transmission of signals;
- at least two connectors (5) fastened on the edges (20) of said base (2) and linked to said controller (4), each connector (5) having :
- an electrical power supply interface for said at least one light signal transmitter (3) and said at least one controller (4); and
- a bidirectional communication interface connected to said at least one controller (4) and having a communication input and a communications output;
wherein at least one of said connectors (5) may be connected with a connector (5) of a neighboring module (1) in the modular installation (IN) for allowing a bidirectional communication between the controller (4) of said module (1) and the controller (4) of said neighboring module (1) and a distribution of the electrical power supply between the modules (1);
said module (1) being **characterized in that** the controller (4) operates on the basis of distributed and synchronous algorithms so as to be able to perform control and monitoring tasks of the light signal transmitter(s) (3), bidirectional communication with the controllers (4) of the neighboring module or modules (1), listening on the communication interfaces of the connectors (5), and receiving and transmitting data on the communication interfaces of the connectors (5).

2. The module (1) according to claim 1, wherein at least one light signal transmitter (3) is of the light-emitting diode type.

3. The module (1) according to claims 1 or 2, further comprising at least one sensor for measuring a local parameter fastened on the base (2), in particular of the proximity sensor type, said at least one sensor generating local measuring data and the controller (4) being linked to said at least one sensor to receive said local measurement data.

4. The module (1) according to any one of the preceding claims, wherein the module (1) includes a connector (5) on each edge (20).

5. A modular installation (IN) of the type comprising several modules (1) in accordance with any one of the preceding claims, wherein each module (1) has at least one connector (5) connected to a connector (5) of a neighboring module (1).

6. The modular installation (IN) according to claim 5, wherein the base (2) of each module (1) has at least one edge (20) on which a connector (5) is fastened, where said edge (20) is contiguous to an edge (20) of the base (2) of an neighboring module (1) on which a connector (5) is also fastened, and the two connectors (5) fastened on said contiguous edges (20) are interconnected.

7. The modular installation (IN) according to claims 5 or 6, wherein the bases (2) of the modules (1) are distributed in a planar or volume tiling, the base (2) of each module (1) being disposed contiguously to the base (2) of at least one neighboring module (1), and each module (1) being connected to its neighboring module(s) (1) through their respective connectors (5).

8. The modular installation (IN) according to any one of claims 5 to 7, further comprising a single source of a driving program of the controllers (4) of the modules (1), said source being provided to be connected to a controller (4) of a module (1) called master module.

9. A method for synchronous driving of a modular installation (IN) of light signal transmitters (3), said method comprising the following steps:
• providing several programmable modules (1), wherein each module (1) comprises:
- a support base (2) delimited by edges (20);
- at least one light signal transmitter (3) fastened on said base (2);
- at least one controller (4) fastened on said base (2) and linked to said at least one light signal transmitter (3) for driving the transmission of signals;
- at least two connectors (5) fastened on the edges (20) of said base (2) and linked to said controller (4), each connector (5) having :
- an electrical power supply interface for said at least one light signal transmitter (3) and said at least one controller (4); and
- a bidirectional communication interface connected to said at least one controller (4) and having a communication input and a communications output;
• connecting the modules (1) to each other so that each module (1) has at least one connector (5) connected to a connector (5) of a neighboring module (1) in the installation (1), wherein two neighboring modules (1) have adjacent edges (20) and the connection between the two neighboring modules (1) is done by connecting the connectors (5) placed on these edges (20);
• establishing bi-directional communication and distribution of the power supply between the controller (4) of each module (1) and the controller (4) of the at least one neighboring module (1) in the installation (1);
• for each module (1), programming the controller (4) to operate on the basis of distributed and synchronous algorithms to perform control and monitoring tasks of the light signal transmitter(s) (3), bidirectional communication with the controllers (4) of the neighboring module or modules (1), listening on the communication interfaces of the connectors (5), and receiving and transmitting data on the communication interfaces of the connectors (5) ;
• for each module (1), executing the same program in a periodic cyclic and synchronous manner, in which, at each cycle, each module (1) establishes a bidirectional communication with the neighboring module(s) (1) and executes one or more distributed and synchronous algorithms of said program.

10. The method according to claim 9, wherein a module called master module constitute a unique source of the periodic timing for the execution of the same program by the modules (1), where said master module generates a synchronization signal which is propagated step by step between the modules (1) starting from the master module via their respective connectors.

11. The method according to claims 9 or 10, wherein the execution of the same program by the modules (1) is preceded by a phase for inputting a driving algorithm to the controller (4) of at least one module (1) called master module, in the form of data frames distributed in successive periodic cycles, the other modules (1) being called slave modules, and in which the execution of the same program by the modules (1) includes the following phases:
- a first phase for executing a distribution algorithm in which the data frames of the driving algorithm are synchronously and periodically distributed, step by step between the modules (1) starting from at least one module (1) called master module;
- once the distributed driving algorithm is completely loaded in all controllers (4), a second phase for synchronously and periodically executing the driving algorithm by each controller (4).

12. The method according to claim 11, wherein the first distribution phase is preceded by a phase for determining a maximum distance corresponding to the greatest distance between the at least one master module (1) and the most distant slave module(s) (1) in the installation (IN) by routing from neighboring module (1) to neighboring module (1) according to the shortest path(s), to establish the time required for the distribution phase so that the distributed driving algorithm is completely loaded in all controllers (4).

13. The method according to claims 11 or 12, wherein the phase for inputting the driving algorithm and the first phase for executing the distribution algorithm are performed:
- either sequentially, where said first phase begins once the driving algorithm is completely loaded in the controller (4) of the at least one master module (1);
- or in parallel, where each controller (4) of a module (1) receives in a current cycle, a data frame of the driving algorithm and propagates them to the controller(s) (4) of the neighboring module(s) (1) in the next cycle.

14. The method according to any one of claims 11 to 13, wherein, during the first phase for executing the distribution algorithm, at each cycle, the controller (4) of each module (1) performs the following operations:
- receiving a synchronization signal on at least one communication input, and transmitting the synchronization signal on the communication outputs;
- listening on all communication inputs of the module (1);
- receiving a data frame of the driving algorithm on at least one communication input of the module (1), said data frame corresponding to a data frame transmitted during the previous cycle by a neighboring module (1) on the communication output connected to said communication input of the module (1);
- storing said data frame in said controller (4);
- transmitting said data frame on the communication outputs to the neighboring modules (1).

15. The method according to any one of claims 11 to 14, wherein, during the second phase for executing the driving algorithm, at each cycle, the controller (4) of each module (1) performs the following operations:
- receiving a synchronization signal on at least one communication input, and transmitting the synchronization signal on the communication outputs;
- listening on all communication inputs of the module (1);
- reading the measurement data coming from the at least one sensor;
- reading variables called state variables representative of the state of the module (1), in particular the state of the at least one light signal transmitter (3);
- reading a data packet called incoming data packet on at least one communication input of the module (1), said data packet integrating at least one input variable for executing of the driving algorithm;
- executing the driving algorithm with, as an input, the input variable(s) of the data packet(s) received in the current cycle, the measurement data and the state variables, and, as an output, driving instructions of the light signal transmitter(s) (3) of the module (1), updating the state variables, and calculating output variables associated with each communications output;
- transmitting on each communication output a data packet called said outgoing data packet integrating the output variables associated with each communication output.

16. The method according to claim 15, wherein, during the second phase for executing the driving algorithm, at each cycle, the incoming data packet or each incoming data packet in a current cycle corresponds to an outgoing data packet transmitted during the previous cycle by a neighboring module (1) on the communication output connected to said communication input of the module (1), and the outgoing data packet or each outgoing data packet transmitted in a current cycle is received by the concerned neighboring module (1) in the next cycle.

17. The method according to claims 15 or 16, wherein the second phase for executing the driving algorithm comprises, preferably at the beginning of the second phase, a communication phase with a unique timing source without jitter control, the unique timing source given by the synchronization signal at the beginning of each cycle sent by the controller (4) of at least one master module (1).

18. The method according to claims 15 or 16, wherein the second phase for executing the driving algorithm comprises, preferably after the starting of the installation (IN), a communication phase with a variable number of timing sources and with jitter control, in which a controller (4) of at least one slave module (1) generates its own synchronization signal that is transmitted to the neighboring modules (1) on its communication outputs.

19. The method according to any one of claims 11 to 18, wherein the second phase for executing the driving algorithm implements a data routing protocol, in which during each cycle the data packets exchanged between two neighboring modules (1) are cut and sent in several groups distributed over time slots longer than an offset time of the propagation between two neighboring modules (1) of rank n and n + 1 respectively, so that each byte of a group of order NO is received on a connector (5) before sending the corresponding byte of a group of a higher order NO + 1 on another connector.
